# EUROPEAN PATENT APPLICATION

(11) **EP 4 064 802 A1**
(43) Date of publication of application: **28.09.2022**
(21) Application number: 20903997.3
(22) Date of filing: 29.10.2020
(51) Int. Cl.: H05K 1/14

(54) **CIRCUIT BOARD ASSEMBLY, ELECTRONIC DEVICE, AND METHOD FOR PROCESSING CIRCUIT BOARD ASSEMBLY**

(30) Priority: 19.12.2019 CN 201911317190
(71) Applicant: HUAWEI TECHNOLOGIES CO., LTD., Shenzhen, Guangdong 518129 (CN)
(72) Inventor: SHI, Hongbin, Shenzhen, Guangdong 518129 (CN); HU, Tianqi, Shenzhen, Guangdong 518129 (CN); CHEN, Yu, Shenzhen, Guangdong 518129 (CN)
(74) Representative: Pfenning, Meinig & Partner mbB
(86) International application number: PCT/CN2020/124790
(87) International publication number: WO 2021/120877

(57) **Abstract**

This application provides a circuit board assembly, which may include a first circuit board and a second circuit board that are fastened together. The first circuit board includes a first side surface and a first sidewall pad. The first sidewall pad is located at a position that is on the first side surface and close to the second circuit board. The second circuit board includes a second sidewall pad or a second horizontal pad. The first sidewall pad, the second sidewall pad, and the second horizontal pad are all located on a same side of the circuit board assembly. Sidewall solder is adhered to the first sidewall pad and the second sidewall pad, or the sidewall solder is adhered to the first sidewall pad and the second horizontal pad. This application provides a circuit board assembly, including a groove for adhering a filling material. This application provides a circuit board assembly and an electronic device, to improve reliability of a connection between circuit boards or between a circuit board and an electronic component.

## Description

This application claims priority to Chinese Patent Application No. 201911317190.9, filed with the China National Intellectual Property Administration on December 19, 2019 and entitled "CIRCUIT BOARD ASSEMBLY, ELECTRONIC DEVICE, AND METHOD FOR PROCESSING CIRCUIT BOARD ASSEMBLY", which is incorporated herein by reference in its entirety.

### TECHNICAL FIELD

This application relates to the field of electronic devices, and more specifically, to a circuit board assembly, an electronic device, and a method for processing a circuit board assembly.

### BACKGROUND

As an electronic device needs to implement increasing functions, an increasing quantity of electronic components are disposed inside the electronic device. The electronic device may include a plurality of circuit boards, and each circuit board may be used to solder and fasten the electronic components. This soldering and fastening process may also be referred to as a soldering technology. To provide larger space for a battery and another function module, a transverse area (XY area) of the circuit board may be reduced through board on board (board on board, BoB) or package on package (package on package, PoP). To ensure connection reliability of the BOB and the PoP, a soldering region needs to be filled with underfill (underfill) materials or edge bond adhesive (edge dond adhesive) materials. This filling technology may also be referred to as a dispensing technology. However, a vertical height (a Z-direction height) for connecting the electronic component or the circuit board is very small (for example, only 40 µm). In addition, solder flux may remain on the circuit board. This is not conducive to effectively put a filling material between solder joints. Further, it is difficult to ensure mechanical reliability and environmental reliability of a circuit board assembly (printed circuit board assembly, PCBA).

### SUMMARY

This application provides a circuit board assembly, an electronic device, and a method for processing a circuit board assembly, to improve reliability of a connection between circuit boards, or between a circuit board and an electronic component.

According to a first aspect, an electronic device is provided, including: a first circuit board, including a first side surface and a first sidewall pad, where the first sidewall pad is disposed on the first side surface; a second circuit board, fastened to the first circuit board, where the first sidewall pad is located at a position close to the second circuit board; and sidewall solder, adhered to the first sidewall pad and the second circuit board.

Optionally, the electronic component further includes a power supply. The power supply is electrically connected to the first circuit board and the second circuit board.

A circuit board mentioned in this application may be a mainboard, a frame board, a daughterboard, a substrate of the electronic component, or the like.

A pad may also be referred to as a solder mask (solder mask). The pad may be disposed on the circuit board in an electroplating manner. A material of the pad may be a metal material such as copper.

A side surface of the circuit board may refer to a surface disposed in parallel to a height direction of the circuit board. For example, the frame board is a circuit board. The frame board may include a via for disposing the electronic component. A side surface of the frame board may include an inner wall of the via, and may further include an outer peripheral surface of the frame board. A surface that is perpendicular to the height direction of the circuit board and used to carry another circuit board or electronic component may be referred to as a horizontal plane of the circuit board. The circuit board may include an upper horizontal plane and a lower horizontal plane.

A solder ball may refer to a solder material connected between a horizontal plane of a circuit board 1 and a horizontal plane of a circuit board 2. The sidewall solder may refer to a solder material disposed on the side surface of the circuit board.

It should be understood that a conventional solder ball may be welded to a copper foil on the horizontal plane of the circuit board. In an embodiment of this application, the sidewall solder may also be adhered to the copper foil on the horizontal plane of the circuit board.

In this embodiment of this application, solder is formed on a side wall. In a case in which electrical properties of the circuit board assembly are not affected, a volume of the sidewall solder may be relatively large, so that relatively high connection strength can be implemented, and mechanical and environmental reliability of the circuit board assembly can be improved. In addition, because of the sidewall solder, a solder ball closest to a periphery of the circuit board can also be protected to some extent. This can delay breakdown of the circuit board assembly. In addition, a spacing between adjacent circuit boards hardly affects formation of the sidewall solder.

With reference to the first aspect, in some implementations of the first aspect, the second circuit board includes a second horizontal pad, and the second horizontal pad is disposed on a second horizontal plane that is of the second circuit board and close to the first circuit board. That the sidewall solder is adhered to the first sidewall pad and the second circuit board is specifically: The sidewall solder is adhered to the first sidewall pad and the second horizontal pad.

The second horizontal pad may be located at a position close to a second side surface of the second circuit board. The second side surface is disposed in parallel to the first side surface. The first side surface may be located on either side of the second side surface. The first side surface and the second side surface may also be coplanar.

In this embodiment of this application, the second horizontal pad is disposed, so that the sidewall solder is formed between the first sidewall pad and the second horizontal pad. Sizes, arrangement positions, and the like of the first circuit board and the second circuit board may not be limited, to adapt to more scenarios.

With reference to the first aspect, in some implementations of the first aspect, the second circuit board includes a second side surface and a second sidewall pad, the first side surface and the second side surface are located on a same side of the electronic device, and the second sidewall pad is disposed at a position that is on the second side surface and close to the first circuit board. That the sidewall solder is adhered to the first sidewall pad and the second circuit board is specifically: The sidewall solder is adhered to the first sidewall pad and the second sidewall pad.

In this embodiment of this application, a distance between the first side surface and the second side surface is relatively short. Consequently, it is difficult to put a filling material between the first circuit board and the second circuit board. Therefore, when the first side surface and the second side surface are fastened together by using the sidewall solder, a process solution for replacing the filling material may be provided.

With reference to the first aspect, in some implementations of the first aspect, the first sidewall pad further includes a sidewall groove, and the sidewall solder is adhered to a surface of the sidewall groove.

A sidewall groove on a sidewall pad may be implemented by using technologies such as laser cutting and a plurality of times of electroplating.

In this embodiment of this application, the sidewall groove is disposed on the sidewall pad, so that the sidewall solder can be adhered to the surface of the sidewall groove. Therefore, a contact area between the sidewall solder and the pad is increased. In addition, a total adhesion volume of the sidewall solder can be increased, so that connection reliability of the sidewall solder can be improved, and mechanical and environmental reliability of the circuit board assembly can be improved.

With reference to the first aspect, in some implementations of the first aspect, the sidewall groove includes a first bottom surface and a first groove wall, the first bottom surface is disposed in parallel to the first side surface, the first groove wall is connected between the first bottom surface and an outer surface of the first sidewall pad, and the first groove wall surrounds a periphery of the first bottom surface, or the first groove wall is located on one side of the first bottom surface.

For the sidewall groove that includes the first bottom surface and the first groove wall surrounding a periphery of the first bottom surface, a contact area between the sidewall pad and the sidewall solder is larger, a connection effect of the sidewall solder is better, and stronger mechanical and environmental reliability can be implemented.

With reference to the first aspect, in some implementations of the first aspect, the first circuit board further includes: a first horizontal pad, located on a first horizontal plane that is of the first circuit board and close to the second circuit board, and located at a position close to the first sidewall pad. The sidewall solder is further adhered to the first horizontal pad.

In this embodiment of this application, a horizontal pad is disposed on the circuit board, so that the contact area between the sidewall solder and the pad can be increased. In addition, the first horizontal pad is disposed, so that the sidewall solder may further fasten a side surface of the first circuit board and a horizontal plane of the second circuit board, thereby providing binding force in a plurality of directions. This is more suitable for a complex drop scenario.

With reference to the first aspect, in some implementations of the first aspect, the first horizontal pad is connected to the first sidewall pad to form a first pad.

In this embodiment of this application, the horizontal pad and the sidewall pad are connected as a whole, so that the sidewall solder is closely adhered to the pad. However, if the horizontal pad and the sidewall pad are spaced from each other, a cavity is prone to form among the sidewall solder, the horizontal pad, and the sidewall pad. This is not conducive to mechanical and environmental reliability of the sidewall solder.

With reference to the first aspect, in some implementations of the first aspect, the first horizontal pad further includes a horizontal groove, and the sidewall solder is adhered to a surface of the horizontal groove.

In this embodiment of this application, the horizontal groove is disposed on the horizontal pad, so that the sidewall solder can be adhered to the surface of the horizontal groove. Therefore, the contact area between the sidewall solder and the pad is increased. In addition, a total adhesion volume of the sidewall solder can be increased, so that connection reliability of the sidewall solder can be improved, and mechanical and environmental reliability of the circuit board assembly can be improved. Because there is a spacing between the horizontal pad and the side surface of the circuit board, it is relatively difficult to adhere the sidewall solder to the horizontal pad. Adhesion resistance of the sidewall solder to the horizontal pad can be reduced by adding the horizontal groove to the horizontal pad.

With reference to the first aspect, in some implementations of the first aspect, the horizontal groove includes a second bottom surface and a second groove wall, the second bottom surface is disposed in parallel to the first horizontal plane, the second groove wall is connected between the second bottom surface and an outer surface of the first horizontal pad, and the second groove wall surrounds a periphery of the second bottom surface, or the second groove wall is located on one side of second bottom surface.

For the horizontal groove that includes the second bottom surface and the second groove wall surrounding a periphery of the second bottom surface, a contact area between the horizontal pad and the sidewall solder is larger, a connection effect of the sidewall solder is better, and stronger mechanical and environmental reliability can be implemented.

With reference to the first aspect, in some implementations of the first aspect, one end that is of the first sidewall pad and far away from the second circuit board extends to a third horizontal plane, and the third horizontal plane is a horizontal plane that is of the first circuit boardand far away from the second circuit board.

In this embodiment of this application, a height of the sidewall pad is increased, so that an electromagnetic shielding effect of the sidewall pad can be improved.

With reference to the first aspect, in some implementations of the first aspect, the first circuit board further includes a third side surface and a first groove. The first groove is located at a position close to the third side surface, and is located on the first horizontal plane that is of the first circuit board and close to the second circuit board. The electronic device further includes: a filling material, adhered between the first groove and the second circuit board.

With reference to the first aspect, in some implementations of the first aspect, the first circuit board further includes a third side surface, and the second circuit board further includes a first groove. The first groove is located at a position close to the third side surface, and is located on the second horizontal plane that is of the second circuit board and close to the first circuit board. The electronic device further includes: a filling material, adhered between the first groove and the first circuit board.

In this embodiment of this application, a groove is disposed, so that a contact area between the filling material and the circuit board can be increased, and a total adhesion volume of the filling material can be increased. This can implement relatively high connection strength, and helps improve mechanical and environmental reliability of the circuit board assembly. In addition, the filling material is disposed on a side surface of a circuit, so that the solder ball closest to the periphery of the circuit board can also be protected to some extent, thereby delaying breakdown of the circuit board assembly. In addition, a filling technology and a sidewall soldering technology may be combined to improve stability of a connection between circuit boards, which is more applicable to various scenarios.

With reference to the first aspect, in some implementations of the first aspect, the electronic device further includes an electronic component disposed in the first groove, and the filling material wraps the electronic component.

In this embodiment of this application, the electronic component is disposed in the groove, so that a quantity of electronic components that can be carried by the circuit board assembly can be increased without increasing space occupied by the circuit board assembly, and arrangement compactness of the electronic components can be improved. In other words, when the quantity of electronic components is fixed, the space occupied by the circuit board assembly can be reduced, and arrangement convenience of the electronic components can be improved.

According to a second aspect, an electronic device is provided, including: a first circuit board, including a first side surface; a second circuit board, fastened to the first circuit board and including a first groove, where the first groove is located at a position close to the first side surface, and is disposed on a second horizontal plane that is of the second circuit board and close to the first circuit board; and a filling material, adhered between the first circuit board and the first groove.

Optionally, the electronic device further includes a power supply. The power supply is electrically connected to the first circuit board and the second circuit board.

It should be noted that the second circuit board includes a third side surface disposed in parallel to the first side surface, and the first side surface and the third side surface are located on a same side of a circuit board assembly. In an example, the third side surface is located on a side that is of the first side surface and away from the first circuit board, and the second circuit board may be configured to carry a filling material. In an example, the third side surface is located on a side that is of the first side surface and close to the first circuit board, and the first circuit board may be configured to carry the filling material. Corresponding to the former, the first groove may carry the filling material, which is more conducive to planning a flow direction of the filling material.

A side surface of a circuit board may refer to a surface disposed in parallel to a height direction of the circuit board. For example, the frame board is a circuit board. The frame board may include a via for disposing the electronic component. A side surface of the frame board may include an inner wall of the via, and may further include an outer peripheral surface of the frame board. A surface that is perpendicular to the height direction of the circuit board and used to carry another circuit board or electronic component may be referred to as a horizontal plane of the circuit board. The circuit board may include an upper horizontal plane and a lower horizontal plane.

In this embodiment of this application, a groove is disposed, so that a contact area between the filling material and the circuit board can be increased, and a total adhesion volume of the filling material can be increased. This can implement relatively high connection strength, and helps improve mechanical and environmental reliability of the circuit board assembly. In addition, the filling material is disposed on a side surface of a circuit, so that a solder ball closest to a periphery of the circuit board can also be protected to some extent, thereby delaying breakdown of the circuit board assembly.

With reference to the second aspect, in some implementations of the second aspect, the first groove includes a bottom surface and a groove wall, the bottom surface is disposed in parallel to the second horizontal plane, the groove wall is connected between the bottom surface and the second horizontal plane, and the groove wall surrounds a periphery of the bottom surface, or the groove wall is located on one side of bottom surface.

For a groove that includes a bottom surface and a groove wall surrounding a periphery of the bottom surface, a contact area between the groove and the filling material is larger. Therefore, a connection effect of the filling material is better, and stronger mechanical and environmental reliability can be implemented.

With reference to the second aspect, in some implementations of the second aspect, the electronic device further includes an electronic component disposed in the first groove, and the filling material wraps the electronic component.

In this embodiment of this application, the electronic component is disposed in the groove, so that a quantity of electronic components that can be carried by the circuit board assembly can be increased without increasing space occupied by the circuit board assembly, and arrangement compactness of the electronic components can be improved. In other words, when the quantity of electronic components is fixed, the space occupied by the circuit board assembly can be reduced, and arrangement convenience of the electronic components can be improved.

With reference to the second aspect, in some implementations of the second aspect, the first circuit board further includes a third groove, the third groove is located at a position close to the first side surface, and is disposed on a first horizontal plane that is of the first circuit board and close to the second circuit board, and the filling material is adhered between the first groove and the third groove.

In this embodiment of this application, grooves are disposed on both the first circuit board and the second circuit board, so that a height for accommodating the filling material between the first circuit board and the second circuit board can be increased, a volume of the filling material can be increased, and a contact area between the filling material and each of the first circuit board and the second circuit board can be increased. This can implement relatively high connection strength, and helps improve mechanical and environmental reliability of the circuit board assembly.

According to a third aspect, a circuit board assembly is provided, including: a first circuit board, including a first side surface and a first sidewall pad, where the first sidewall pad is disposed on the first side surface; a second circuit board, fastened to the first circuit board, where the first sidewall pad is located at a position close to the second circuit board; and sidewall solder, adhered to the first sidewall pad and the second circuit board.

With reference to the third aspect, in some implementations of the third aspect, the second circuit board includes a second horizontal pad, and the second horizontal pad is disposed on a second horizontal plane that is of the second circuit board and close to the first circuit board. That the sidewall solder is adhered to the first sidewall pad and the second circuit board is specifically: The sidewall solder is adhered to the first sidewall pad and the second horizontal pad.

With reference to the third aspect, in some implementations of the third aspect, the second circuit board includes a second side surface and a second sidewall pad, the first side surface and the second side surface are located on a same side of the circuit board assembly, and the second sidewall pad is disposed at a position that is on the second side surface and close to the first circuit board. That the sidewall solder is adhered to the first sidewall pad and the second circuit board is specifically: The sidewall solder is adhered to the first sidewall pad and the second sidewall pad.

With reference to the third aspect, in some implementations of the third aspect, the first sidewall pad further includes a sidewall groove, and the sidewall solder is adhered to a surface of the sidewall groove.

With reference to the third aspect, in some implementations of the third aspect, the sidewall groove includes a first bottom surface and a first groove wall, the first bottom surface is disposed in parallel to the first side surface, the first groove wall is connected between the first bottom surface and an outer surface of the first sidewall pad, and the first groove wall surrounds a periphery of the first bottom surface, or the first groove wall is located on one side of the first bottom surface.

With reference to the third aspect, in some implementations of the third aspect, the first circuit board further includes: a first horizontal pad, located on a first horizontal plane that is of the first circuit board and close to the second circuit board, and located at a position close to the first sidewall pad. The sidewall solder is further adhered to the first horizontal pad.

With reference to the third aspect, in some implementations of the third aspect, the first horizontal pad is connected to the first sidewall pad to form a first pad.

With reference to the third aspect, in some implementations of the third aspect, the first horizontal pad further includes a horizontal groove, and the sidewall solder is adhered to a surface of the horizontal groove.

With reference to the third aspect, in some implementations of the third aspect, the horizontal groove includes a second bottom surface and a second groove wall, the second bottom surface is disposed in parallel to the first horizontal plane, the second groove wall is connected between the second bottom surface and an outer surface of the first horizontal pad, and the second groove wall surrounds a periphery of the second bottom surface, or the second groove wall is located on one side of second bottom surface.

With reference to the third aspect, in some implementations of the third aspect, one end that is of the first sidewall pad and far away from the second circuit board extends to a third horizontal plane, and the third horizontal plane is a horizontal plane that is of the first circuit board and far away from the second circuit board.

With reference to the third aspect, in some implementations of the third aspect, the first circuit board further includes a third side surface and a first groove. The first groove is located at a position close to the third side surface, and is located on the first horizontal plane that is of the first circuit board and close to the second circuit board. The circuit board assembly further includes: a filling material, adhered between the first groove and the second circuit board.

With reference to the third aspect, in some implementations of the third aspect, the first circuit board further includes a third side surface, and the second circuit board further includes a first groove. The first groove is located at a position close to the third side surface, and is located on the second horizontal plane that is of the second circuit board and close to the first circuit board. The circuit board assembly further includes: a filling material, adhered between the first groove and the first circuit board.

With reference to the third aspect, in some implementations of the third aspect, the circuit board assembly further includes an electronic component disposed in the first groove, and the filling material wraps the electronic component.

According to a fourth aspect, a circuit board assembly is provided, including: a first circuit board, including a first side surface; a second circuit board, fastened to the first circuit board and including a first groove, where the first groove is located at a position close to the first side surface, and is disposed on a second horizontal plane that is of the second circuit board and close to the first circuit board; and a filling material, adhered between the first circuit board and the first groove.

With reference to the fourth aspect, in some implementations of the fourth aspect, the first groove includes a bottom surface and a groove wall, the bottom surface is disposed in parallel to the second horizontal plane, the groove wall is connected between the bottom surface and the second horizontal plane, and the groove wall surrounds a periphery of the bottom surface, or the groove wall is located on one side of bottom surface.

With reference to the fourth aspect, in some implementations of the fourth aspect, the circuit board assembly further includes an electronic component disposed in the first groove, and the filling material wraps the electronic component.

With reference to the fourth aspect, in some implementations of the fourth aspect, the first circuit board further includes a third groove, the third groove is located at a position close to the first side surface, and is disposed on a first horizontal plane that is of the first circuit board and close to the second circuit board, and the filling material is adhered between the first groove and the third groove.

According to a fifth aspect, a method for processing a circuit board assembly is provided, including: an electroplating step, including: electroplating a first side surface of a first circuit board with a first sidewall pad; and a soldering step, including: soldering the first circuit board to a second circuit board, and performing soldering between the first sidewall pad and the second circuit board to form sidewall solder.

An embodiment of this application provides a soldering manner different from a conventional soldering technology, to implement a connection effect with higher strength.

With reference to the fifth aspect, in some implementations of the fifth aspect, the electroplating step further includes: electroplating a second side surface of the second circuit board with a second sidewall pad, where the second sidewall pad is located at a position close to the first sidewall pad, and the second side surface and the first side surface are disposed in parallel to each other, and are located on a same side of the circuit board assembly. The performing soldering between the first sidewall pad and the second circuit board to form sidewall solder includes: performing soldering between the first sidewall pad and the second sidewall pad to form the sidewall solder.

With reference to the fifth aspect, in some implementations of the fifth aspect, the electroplating step further includes: electroplating a second horizontal plane of the second circuit board with a second horizontal pad, where the second horizontal plane is a horizontal plane that is of the second circuit board and close to the first circuit board, and the second horizontal pad is located at the position close to the first sidewall pad. The performing soldering between the first sidewall pad and the second circuit board to form sidewall solder includes: performing soldering between the first sidewall pad and the second horizontal pad to form the sidewall solder.

With reference to the fifth aspect, in some implementations of the fifth aspect, the electroplating step further includes: electroplating a first horizontal plane of the first circuit board with a first horizontal pad, where the first horizontal plane is a horizontal plane that is of the first circuit board and close to the second circuit board. The performing soldering between the first sidewall pad and the second circuit board to form sidewall solder includes: performing soldering among the first sidewall pad, the first horizontal pad, and the second circuit board to form the sidewall solder.

With reference to the fifth aspect, in some implementations of the fifth aspect, the electroplating step further includes: electroplating the first horizontal pad to form a horizontal groove.

With reference to the fifth aspect, in some implementations of the fifth aspect, the electroplating step further includes: electroplating the first sidewall pad to form a sidewall groove.

### BRIEF DESCRIPTION OF DRAWINGS

FIG. 1 is a schematic diagram of a structure of an electronic device;
FIG. 2 is a schematic diagram of a structure of a circuit board assembly;
FIG. 3 is a schematic diagram of a structure of a circuit board assembly according to an embodiment of this application;
FIG. 4(a) and FIG. 4(b) are a schematic diagram of structures of two circuit board assemblies according to an embodiment of this application;
FIG. 5(a) and FIG. 5(b) are a schematic diagram of structures of two sidewall grooves according to an embodiment of this application;
FIG. 6 is a schematic diagram of a structure of a circuit board assembly according to an embodiment of this application;
FIG. 7 is a schematic diagram of a structure of a circuit board assembly according to an embodiment of this application;
FIG. 8(a) and FIG. 8(b) are a schematic diagram of structures of two circuit board assemblies according to an embodiment of this application;
FIG. 9(a) and FIG. 9(b) are a schematic diagram of structures of two horizontal grooves according to an embodiment of this application;
FIG. 10 is a schematic diagram of a structure of a circuit board assembly according to an embodiment of this application;
FIG. 11 is a schematic diagram of a structure of a circuit board assembly according to an embodiment of this application;
FIG. 12 is a schematic diagram of a structure of a circuit board assembly according to an embodiment of this application;
FIG. 13 is a schematic diagram of a structure of a circuit board assembly according to an embodiment of this application;
FIG. 14 is a schematic diagram of a structure of a circuit board assembly according to an embodiment of this application;
FIG. 15 is a schematic diagram of a structure of a circuit board assembly according to an embodiment of this application;
FIG. 16 is a schematic diagram of a structure of a circuit board assembly according to an embodiment of this application;
FIG. 17 is a schematic diagram of a structure of a circuit board assembly according to an embodiment of this application;
FIG. 18 is a schematic diagram of a structure of a circuit board assembly according to an embodiment of this application;
FIG. 19 is a schematic diagram of a structure of a circuit board assembly according to an embodiment of this application;
FIG. 20 is a schematic diagram of a structure of a circuit board assembly according to an embodiment of this application;
FIG. 21 is a schematic flowchart of a method for processing a circuit board assembly according to an embodiment of this application;
FIG. 22 is a schematic diagram of a structure of a circuit board assembly according to an embodiment of this application;
FIG. 23 is a schematic diagram of a structure of a circuit board assembly according to an embodiment of this application;
FIG. 24 is a schematic diagram of a structure of a circuit board assembly according to an embodiment of this application;
FIG. 25 is a schematic diagram of a structure of a circuit board assembly according to an embodiment of this application;
FIG. 26 is a schematic diagram of a structure of a circuit board assembly according to an embodiment of this application;
FIG. 27 is a schematic diagram of a structure of a circuit board assembly according to an embodiment of this application;
FIG. 28 is a schematic diagram of a structure of a circuit board assembly according to an embodiment of this application;
FIG. 29 is a schematic diagram of a structure of a circuit board assembly according to an embodiment of this application;
FIG. 30 is a schematic diagram of a structure of a circuit board assembly according to an embodiment of this application;
FIG. 31 is a schematic diagram of a structure of a circuit board assembly according to an embodiment of this application;
FIG. 32 is a schematic diagram of a structure of a circuit board assembly according to an embodiment of this application;
FIG. 33 is a schematic diagram of a structure of a circuit board assembly according to an embodiment of this application; and
FIG. 34 is a schematic diagram of a structure of a circuit board assembly according to an embodiment of this application.

### DESCRIPTION OF EMBODIMENTS

The following describes technical solutions of this application with reference to accompanying drawings.

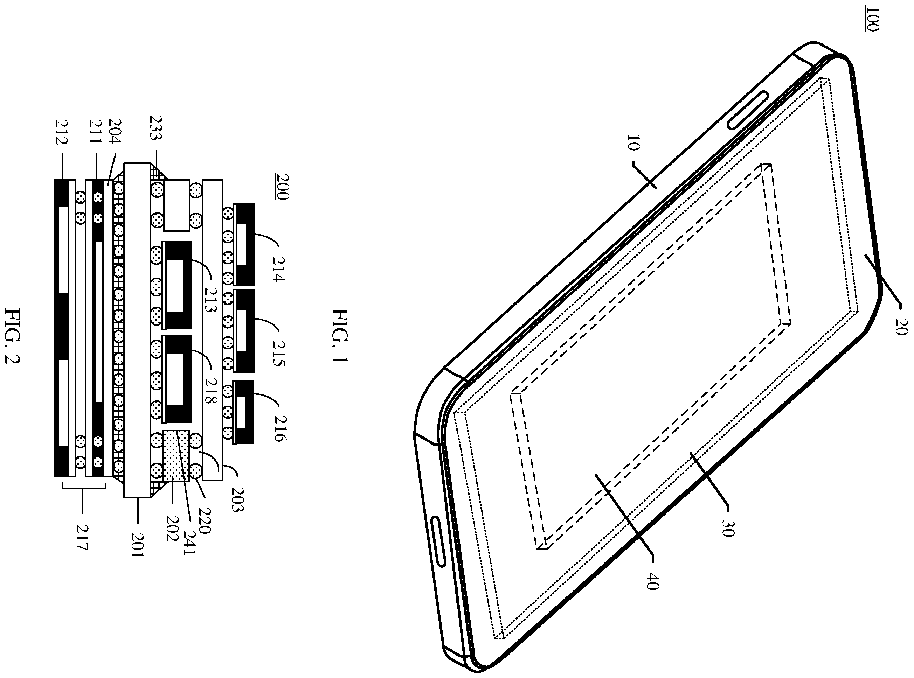

FIG. 1 is a schematic diagram of a structure of an electronic device 100 according to an embodiment of this application.

The electronic device 100 may be a device such as a mobile phone, a tablet computer, an electronic reader, a notebook computer, a digital camera, a vehicle-mounted device, or a wearable device. In the embodiment shown in FIG. 1, an example in which the electronic device 100 is the mobile phone is used for description.

The electronic device 100 includes a housing 10, a display 20, and a circuit board assembly 30. The display 20 and the circuit board assembly 30 are installed on the housing 10. Specifically, the housing 10 includes a frame and a rear cover. The frame surrounds a periphery of the display 20 and a periphery of the rear cover. The display 20 and the rear cover are spaced from each other. A cavity formed among the display 20, the frame, and the rear cover is used to place the circuit board assembly 30. The electronic device 100 further includes a power supply 40 configured to supply power to the circuit board assembly 30. The power supply 40 may be, for example, a lithium-ion battery.

FIG. 2 is a schematic diagram of a structure of a circuit board assembly according to an embodiment of this application. A circuit board assembly 200 may be an example of the circuit board assembly 30 of the electronic device 100 shown in FIG. 1. The circuit board assembly 200 may be a printed circuit board assembly (printed circuit board assembly, PCBA). The circuit board assembly 200 may include a plurality of printed circuit boards (printed circuit board, PCB) and a plurality of electronic components electrically connected to the PCBs. A drum pattern in FIG. 2 may represent a solder ball 220 for mechanical and environmental fixation and/or electrical connection. It should be understood that the solder ball described in this application actually refers to solder that is mechanically and environmentally connected and/or electrically connected between circuit boards, or refers to solder that is mechanically and environmentally connected and/or electrically connected between a circuit board and an electronic component. In this application, a real shape of the solder ball is not necessarily a spherical shape, but may be a polyhedron, an ellipsoid, a round table, a chamfer, or the like. For ease of description, solder of various shapes is collectively referred to as the solder ball in this application. The solder ball shown in the figure is merely an example, and parameters such as a shape and a size of the solder ball are not limited in this application.

As shown in FIG. 2, the plurality of PCBs include a PCB 201, a PCB 202, and a PCB 203. The PCB 201, the PCB 202, and the PCB 203 are fastened together by using solder balls 220, and the PCB 202 is located between the PCB 201 and the PCB 203. The PCB 201 may be a mainboard. The PCB 202 may be a frame board. The PCB 202 may include a via 241 for accommodating an electronic component. The PCB 203 may be a daughterboard. The power supply in FIG. 1 may be configured to supply power to the PCB 201, the PCB 202, the PCB 203, and/or the plurality of electronic components.

The plurality of electronic components electrically connected to the plurality of PCBs may include, for example, a system-on-a-chip (system on chip, SOC) component 211, a double data rate (double data rate, DDR) memory 212, a primary power management unit (power management unit, PMU) 213, a radio frequency integrated circuit (radio frequency integrated circuit, RF IC) 214, a radio frequency power amplifier (radio frequency power amplifier, RF PA) 215, a wireless fidelity (wireless fidelity, Wi-Fi) chip 216, and a secondary PMU 218. The plurality of electronic components may be stacked and packaged to form a package on package (Package on Package, POP) component. As shown in FIG. 2, the SOC component 211 may be stacked with the DDR memory 212 to form a POP component 217. A substrate 204 of the POP component 217 may be fastened, by using solder balls 220, on a side that is of the PCB 201 and away from the PCB 202. The PMU 213 may be fastened, by using solder balls 220, on a side that is of the PCB 201 and close to the PCB 202, and extend into the via 241 of the PCB 202. All of the RF IC 214, the RF PA 215, and the Wi-Fi chip 216 may be fastened, by using solder balls 220, on a side that is of the PCB 203 and away from the PCB 201.

To ensure connection strength, a filling material 233 may be put between the circuit boards, or between the circuit board and the electronic component. A pattern filled with rectangles in FIG. 2 may represent the filling material 233. For example, some filling materials 233 may be put between the PCB 201 and the POP component 217, so that the filling materials 233 may wrap the solder balls 220 between the PCB 201 and the POP component 217. A filling technology in which a filling material can wrap a plurality of solder balls may be referred to as underfill (underfill). For another example, some filling materials 233 may be put between the PCB 201 and the PCB 202, so that the filling materials 233 may be adhered to a periphery of the PCB 202. A filling technology in which a filling material can be adhered to a periphery of the circuit board or the electronic component may be referred to as edge bonding (edge bonding).

In conclusion, a total height of the electronic device is usually relatively thin. Therefore, a height of a solder joint between the circuit board and the electronic component is very small, and a height of a solder joint between the circuit boards is also very small, for example, only 40 µm. Consequently, it is difficult for the filling material to achieve effective adhesion, and it is difficult to ensure mechanical and environmental reliability of the circuit board assembly. Embodiments of this application provide a circuit board assembly, an electronic device, and a method for processing a circuit board assembly, to improve reliability of a connection between circuit boards, or between a circuit board and an electronic component, so as to ensure mechanical and environmental reliability of the circuit board assembly and the electronic device.

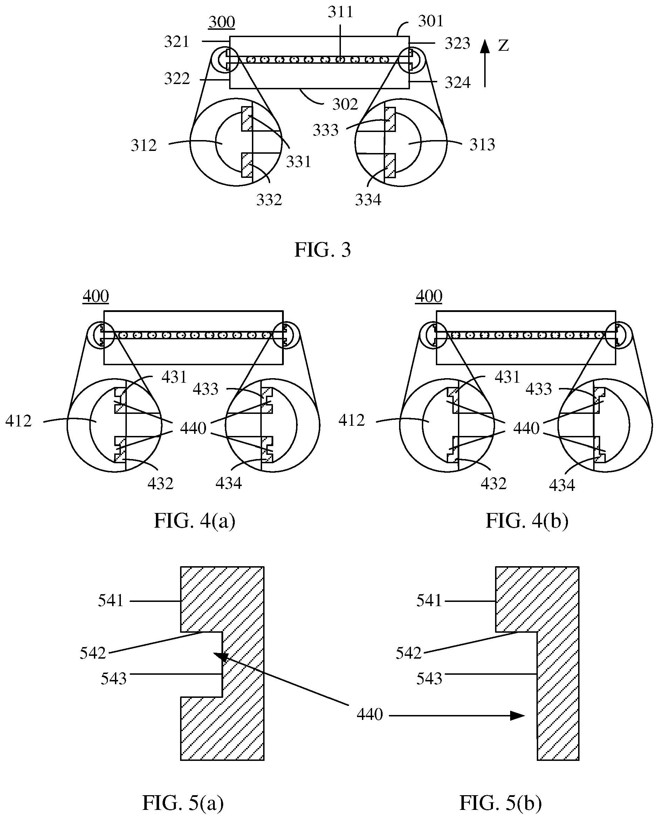

FIG. 3 is a schematic diagram of a structure of a circuit board assembly according to an embodiment of this application. A circuit board assembly 300 may be, for example, the circuit board assembly 30 in FIG. 1, or a part of the circuit board assembly 30.

The circuit board assembly 300 may include a first circuit board 301 and a second circuit board 302. The second circuit board 302 may be fastened to the first circuit board 301 by using solder balls 311. In an example, the first circuit board 301 may be, for example, the frame board 202 in FIG. 2, and the second circuit board 302 may be, for example, the mainboard 201 in FIG. 2. In an example, the first circuit board 301 may be, for example, the daughterboard 203 in FIG. 2, and the second circuit board 302 may be, for example, the frame board 202 in FIG. 2. In an example, the first circuit board 301 may be, for example, the substrate 204 included in the POP component in FIG. 2 (an electronic component with a relatively large size usually includes a substrate 204, and the substrate 204 is a circuit board), and the second circuit board 302 may be, for example, the mainboard 201 in FIG. 2. It should be noted that the circuit board mentioned in this application may be a mainboard, a frame board, a daughterboard, a substrate of an electronic component, or the like.

The first circuit board 301 includes a first side surface 321 and a first sidewall pad 331. The first sidewall pad 331 is disposed at a position that is on the first side surface 321 and close to the second circuit board 302. The second circuit board 302 includes a second side surface 322 and a second sidewall pad 332. The first side surface 321 is disposed in parallel to the second side surface 322. The first side surface 321 and the second side surface 322 are located on a same side of the circuit board assembly 300. The second sidewall pad 332 is disposed at a position that is on the second side surface 322 and close to the first circuit board 301. First sidewall solder 312 is adhered to the first sidewall pad 331 and the second sidewall pad 332. Similarly, the first circuit board 301 includes a third side surface 323. A third sidewall pad 333 is disposed at a position that is on the third side surface 323 and close to the second circuit board 302. The second circuit board 302 includes a fourth side surface 324. The third side surface 323 is disposed in parallel to the fourth side surface 324. The third side surface 323 and the fourth side surface 324 are located on a same side of the circuit board assembly 300. A fourth sidewall pad 334 is disposed at a position that is on the fourth side surface 324 and close to the first circuit board 301. Second sidewall solder 313 is adhered to the third sidewall pad 333 and the fourth sidewall pad 334. The first sidewall solder 312 and the second sidewall solder 313 may fasten a side surface of the first circuit board 301 to a side surface of the second circuit board 302, so that the first circuit board 301 and the second circuit board 302 are fastened together.

It should be noted that, in this application, a pattern filled with slashes may represent a pad. The pad may also be referred to as a solder mask (solder mask). The pad may be disposed on the circuit board in an electroplating manner. A material of the pad may be a metal material, for example, copper.

It should be noted that a side surface of the circuit board may be a surface disposed in parallel to a height direction (for example, a Z direction indicated by an arrow in FIG. 3) of the circuit board. For example, the frame board is a circuit board. The frame board may include a via for disposing an electronic component. A side surface of the frame board may include an inner wall of the via, and may further include an outer peripheral surface of the frame board. A surface perpendicular to the height direction of the circuit board may be referred to as a horizontal plane of the circuit board. The circuit board may include an upper horizontal plane and a lower horizontal plane. The horizontal plane of the circuit board may be used to carry another circuit board or an electronic component.

It should be noted that, in this application, a solder ball may refer to a solder material connected between a horizontal plane of a circuit board 1 and a horizontal plane of a circuit board 2. Sidewall solder may refer to a solder material disposed on the side surface of the circuit board.

It can be known from a drop test of the circuit board assembly that, solder balls close to a periphery of the circuit board usually bear relatively large mechanical and environmental stresses, and solder balls close to the center of the circuit board usually bear relatively small mechanical and environmental stresses. Solder is formed on a side wall, so that a solder ball closest to the periphery of the circuit board can also be protected to some extent, thereby delaying breakdown of the circuit board assembly. In addition, a spacing between adjacent circuit boards hardly affects formation of the sidewall solder. Therefore, in a case in which electrical properties of the circuit board assembly are not affected, a volume of the sidewall solder may be relatively large, so that relatively high connection strength can be implemented, and mechanical and environmental reliability of the circuit board assembly can be improved.

FIG. 4(a) is a schematic diagram of a structure of a circuit board assembly according to an embodiment of this application. FIG. 4(b) is a schematic diagram of a structure of a circuit board assembly according to an embodiment of this application. A difference between a circuit board assembly 400 shown in FIG. 4(a) and FIG. 4(b) and the circuit board assembly 300 shown in FIG. 3 includes: A first sidewall pad 431 includes a sidewall groove 440, and first sidewall solder 412 is adhered to a surface of the sidewall groove 440. Because a sidewall pad is located on a side surface of a circuit board, a height direction of the sidewall groove is parallel to a horizontal plane of the circuit board. Similarly, as shown in FIG. 4(a) and FIG. 4(b), sidewall grooves 440 may be disposed on all of a second sidewall pad 432, a third sidewall pad 433, and a fourth sidewall pad 434. The sidewall groove on the sidewall pad may be implemented by using technologies such as laser cutting and a plurality of times of electroplating.

The sidewall groove is disposed on the sidewall pad, so that sidewall solder can be adhered to a surface of the sidewall groove. Therefore, a contact area between the sidewall solder and the pad is increased. In addition, a total adhesion volume of the sidewall solder can be increased, so that connection reliability of the sidewall solder can be improved, and mechanical and environmental reliability of the circuit board assembly can be improved.

As shown in FIG. 5(a) and FIG. 5(b), the sidewall groove 440 may include a first bottom surface 543 and a first groove wall 542. The first bottom surface 543 is disposed in parallel to the side surface of the circuit board. The first groove wall 542 may be connected between the first bottom surface 543 and an outer surface 541 of the sidewall pad (for example, an outer surface of the first sidewall pad 431). As shown in FIG. 4(a), the first groove wall 542 may surround a periphery of the first bottom surface 543, so that an outlet of the sidewall groove 440 is located on the outer surface 541 of the sidewall pad. As shown in FIG. 4(b), the first groove wall 542 may be located on one side of the first bottom surface 543, to be specific, the first bottom surface 543 includes a part directly connected to the first groove wall 542 and a part away from the first groove wall 542. Compared with the sidewall pad shown in FIG. 4(b), the sidewall pad shown in FIG. 4(a) has a larger contact area with the sidewall solder, a connection effect of the sidewall solder is better, and stronger mechanical and environmental reliability can be implemented. It should be understood that a surface of the sidewall pad includes the outer surface of the sidewall pad and the surface of the sidewall groove. That is, the outer surface of the sidewall pad does not include the surface of the sidewall groove.

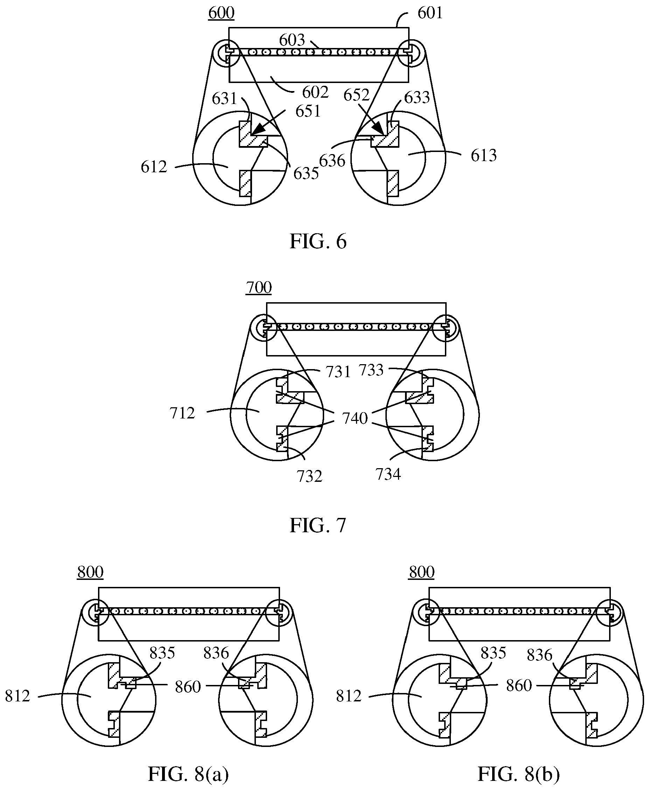

FIG. 6 is a schematic diagram of a structure of a circuit board assembly according to an embodiment of this application. A difference between a circuit board assembly 600 shown in FIG. 6 and the circuit board assembly 300 shown in FIG. 3 includes: A first circuit board 601 further includes a first horizontal pad 635. The first horizontal pad 635 is disposed on a first horizontal plane 603 that is of the first circuit board 601 and close to a second circuit board 602. In addition, the first horizontal pad 635 is located at a position close to a first sidewall pad 631, so that first sidewall solder 612 may also be adhered to the first horizontal pad 635. Similarly, the first circuit board 601 further includes a third horizontal pad 636. The third horizontal pad 636 is located on the first horizontal plane 603 that is of the first circuit board 601 and close to the second circuit board 602, and is located at a position close to a third sidewall pad 633. Second sidewall solder 613 may also be adhered to the third horizontal pad 636. Compared with the circuit board assembly shown in FIG. 3, a horizontal pad is disposed on the circuit board, so that a contact area between sidewall solder and a pad can be increased. In addition, the first horizontal pad 635 and the third horizontal pad 636 are disposed, so that the sidewall solder may further fasten a side surface of the first circuit board 601 and a horizontal plane of the second circuit board 602, thereby providing binding force in a plurality of directions. This is more suitable for a complex drop scenario.

It should be noted that the first circuit board 601 may include a first pad 651, and the first pad 651 includes the first sidewall pad 631 and the first horizontal pad 635, that is, the first sidewall pad 631 and the first horizontal pad 635 are connected as a whole. Similarly, the first circuit board 601 may include a third pad 652, and the third pad 652 includes the third sidewall pad 633 and the third horizontal pad 636, that is, the third sidewall pad 633 and the third horizontal pad 636 are connected as a whole. The horizontal pad and the sidewall pad are connected as a whole, so that the sidewall solder is closely adhered to the pad. However, if the horizontal pad and the sidewall pad are spaced from each other, a cavity is prone to form among the sidewall solder, the horizontal pad, and the sidewall pad. This is not conducive to mechanical and environmental reliability of the sidewall solder.

FIG. 7 is a schematic diagram of a structure of a circuit board assembly according to an embodiment of this application. A difference between a circuit board assembly 700 shown in FIG. 7 and the circuit board assembly 600 shown in FIG. 6 includes: A first sidewall pad 731 includes a sidewall groove 740, and first sidewall solder is adhered to a surface of the sidewall groove 740. Similarly, as shown in FIG. 7, sidewall grooves 740 may be disposed on all of a second sidewall pad 732, a third sidewall pad 733, and a fourth sidewall pad 734. The sidewall groove 740 may include a first bottom surface and a first groove wall, and the first bottom surface is disposed in parallel to a side surface of a circuit board. In the example shown in FIG. 7, the first groove wall is connected between a surface of a sidewall pad and the first bottom surface, and the first groove wall surrounds a periphery of the first bottom surface. In addition to the example shown in FIG. 7, in another example, the first groove wall may alternatively be located on a side of the first bottom surface, and the first bottom surface includes a part directly connected to the first groove wall and a part away from the first groove wall. The foregoing describes, by using the example in FIG. 4(a) and FIG. 4(b), an effect of disposing the sidewall groove 740 on the sidewall pad. Details are not described herein again.

FIG. 8(a) is a schematic diagram of a structure of a circuit board assembly according to an embodiment of this application. FIG. 8(b) is a schematic diagram of a structure of a circuit board assembly according to an embodiment of this application. A difference between a circuit board assembly 800 shown in FIG. 8(a) and FIG. 8(b) and the circuit board assembly 700 shown in FIG. 7 includes: A first horizontal pad 835 includes a horizontal groove 860, and first sidewall solder 812 is adhered to a surface of the horizontal groove 860. Because a horizontal pad is located on a horizontal plane of a circuit board, a height direction of a horizontal groove is perpendicular to the horizontal plane of the circuit board. Similarly, a horizontal groove 860 may also be disposed on a third horizontal pad 836.

The horizontal groove is disposed on the horizontal pad, so that sidewall solder can be adhered to the surface of the horizontal groove. Therefore, a contact area between the sidewall solder and a pad is increased. In addition, a total adhesion volume of the sidewall solder can be increased, so that connection reliability of the sidewall solder can be improved, and mechanical and environmental reliability of the circuit board assembly can be improved. Because there is a spacing between the horizontal pad and a side surface of the circuit board, it is relatively difficult to adhere the sidewall solder to the horizontal pad. Adhesion resistance of the sidewall solder to the horizontal pad can be reduced by adding the horizontal groove to the horizontal pad.

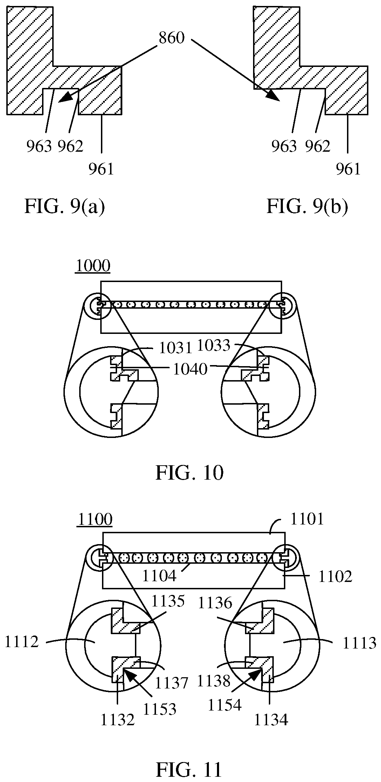

As shown in FIG. 9(a) and FIG. 9(b), the horizontal groove 860 may include a second bottom surface 963 and a second groove wall 962, the second bottom surface 963 is disposed in parallel to the horizontal plane of the circuit board, and the second groove wall 962 may be connected between the second bottom surface 963 and an outer surface 961 of the horizontal pad of the circuit board. As shown in FIG. 8(a), the second groove wall 962 may surround a periphery of the second bottom surface 963, so that an outlet of the horizontal groove 860 is located on the outer surface 961 of the horizontal pad. As shown in FIG. 8(b), the second groove wall 962 may be located on one side of the second bottom surface 963, to be specific, the second bottom surface 963 includes a part directly connected to the second groove wall 962 and a part away from the second groove wall 962. Compared with the horizontal pad shown in FIG. 8(b), the horizontal pad shown in FIG. 8(a) has a larger contact area with the sidewall solder, a connection effect of the sidewall solder is better, and stronger mechanical and environmental reliability can be implemented. It should be understood that a surface of the horizontal pad includes the outer surface of the horizontal pad and the surface of the horizontal groove. That is, the outer surface of the horizontal pad does not include the surface of the horizontal groove.

FIG. 10 is a schematic diagram of a structure of a circuit board assembly according to an embodiment of this application. A difference between a circuit board assembly 1000 shown in FIG. 10 and the circuit board assembly 800 shown in FIG. 8(a) and FIG. 8(b) includes: Sidewall grooves 1040 may be disposed on both a first sidewall pad 1031 and a third sidewall pad 1033. The foregoing describes, by using the example in FIG. 7, an effect of disposing the sidewall groove on the sidewall pad. Details are not described herein again.

FIG. 11 is a schematic diagram of a structure of a circuit board assembly according to an embodiment of this application. A difference between a circuit board assembly 1100 shown in FIG. 11 and the circuit board assembly 600 shown in FIG. 6 includes: A second circuit board 1102 further includes a second horizontal pad 1137. The second horizontal pad 1137 is located on a second horizontal plane 1104 that is of the second circuit board 1102 and close to a first circuit board 1101. In addition, the second horizontal pad 1137 is located at a position close to a second sidewall pad 1132, so that first sidewall solder 1112 may also be adhered to the second horizontal pad 1137. Similarly, the second circuit board 1102 further includes a fourth horizontal pad 1138. The fourth horizontal pad 1138 is located on the second horizontal plane 1104 that is of the second circuit board 1102 and close to the first circuit board 1101, and is located at a position close to a fourth sidewall pad 1134, so that second sidewall solder 1113 may also be adhered to the fourth horizontal pad 1138. Compared with the circuit board assembly 600 shown in FIG. 6, horizontal pads are disposed on a same side of two circuit boards, so that a contact area between sidewall solder and a pad can be further increased. In addition, a first horizontal pad 1135, the second horizontal pad 1137, a third horizontal pad 1136, and the fourth horizontal pad 1138 are disposed, so that the sidewall solder may further fasten a horizontal plane of the second circuit board 1102 and a horizontal plane of the first circuit board 1101, thereby providing binding force in more directions. This is more suitable for a complex drop scenario.

It should be noted that the second circuit board 1102 may include a second pad 1153, and the second pad 1153 includes the second sidewall pad 1132 and the second horizontal pad 1137, that is, the second sidewall pad 1132 and the second horizontal pad 1137 are connected as a whole. Similarly, the second circuit board 1102 may include a fourth pad 1154, and the fourth pad 1154 includes the fourth sidewall pad 1134 and the fourth horizontal pad 1138, that is, the fourth sidewall pad 1134 and the fourth horizontal pad 1138 are connected as a whole. The foregoing has described beneficial effects of connecting the sidewall pad and the horizontal pad as a whole. Details are not described herein again.

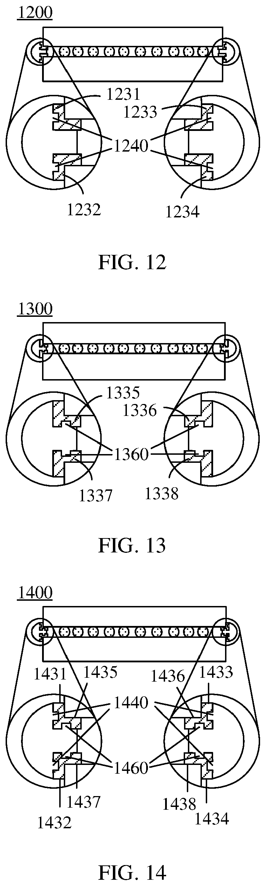

With reference to the embodiments shown in FIG. 7 to FIG. 10, it can be learned that a sidewall pad may include a sidewall groove, and/or a horizontal pad may include a horizontal groove. In other words, at least one of a second sidewall pad, a first sidewall pad, a fourth sidewall pad, and a third sidewall pad may include a sidewall groove; and/or at least one of a first horizontal pad, a third horizontal pad, a second horizontal pad, and a fourth horizontal pad may include a horizontal groove. In a circuit board assembly shown in FIG. 12, a first sidewall pad 1231, a second sidewall pad 1232, a third sidewall pad 1233, and a fourth sidewall pad 1234 each may include a sidewall groove 12340. In a circuit board assembly shown in FIG. 13, a first horizontal pad 1335, a second horizontal pad 1337, a third horizontal pad 1336, and a fourth horizontal pad 1338 each may include a horizontal groove 1360. In a circuit board assembly shown in FIG. 14, a first sidewall pad 1431, a second sidewall pad 1432, a third sidewall pad 1433, and a fourth sidewall pad 1434 each may include a sidewall groove 1440, and a first horizontal pad 1435, a second horizontal pad 1437, a third horizontal pad 1436, and a fourth horizontal pad 1438 each may include a horizontal groove 1460.

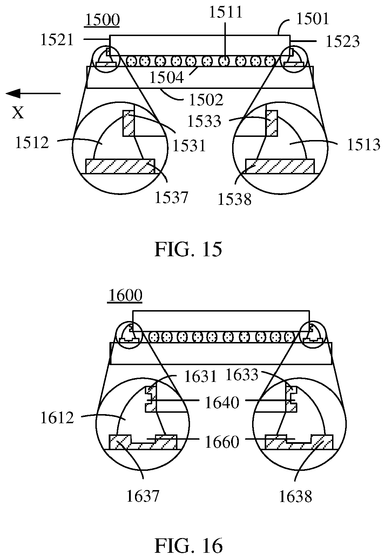

FIG. 15 is a schematic diagram of a structure of a circuit board assembly according to an embodiment of this application. A circuit board assembly 1500 may be, for example, the circuit board assembly 30 in FIG. 1, or a part of the circuit board assembly 30.

The circuit board assembly 1500 may include a first circuit board 1501 and a second circuit board 1502. The first circuit board 1501 may be fastened to the second circuit board 1502 by using solder balls 1511. In an example, the first circuit board 1501 may be, for example, the frame board 202 in FIG. 2, and the second circuit board 1502 may be, for example, the mainboard 201 in FIG. 2. In an example, the first circuit board 1501 may be, for example, the daughterboard 203 in FIG. 2, and the second circuit board 1502 may be, for example, the frame board 202 in FIG. 2. In an example, the first circuit board 1501 may be, for example, the substrate 204 included in the POP component in FIG. 2, and the second circuit board 1502 may be, for example, the mainboard 201 in FIG. 2.

A first sidewall pad 1531 is disposed on a first side surface 1521 of the first circuit board 1501. A second horizontal pad 1537 is disposed on a second horizontal plane 1504 that is of the second circuit board 1502 and close to the first circuit board 1501. The second horizontal pad 1537 is located at a position close to the first side surface 1521. First sidewall solder 1512 is adhered to the first sidewall pad 1531 and the second horizontal pad 1537. Similarly, a third sidewall pad 1533 is disposed on a third side surface 1523 of the first circuit board 1501; a fourth horizontal pad 1538 is disposed on the second horizontal plane 1504 that is of the second circuit board 1502 and close to the first circuit board 1501; the fourth horizontal pad 1538 is located at a position close to the third side surface 1523; and second sidewall solder 1513 is adhered to the third sidewall pad 1533 and the fourth horizontal pad 1538. A pad may also be referred to as a solder mask (solder mask). The first sidewall solder 1512 and the second sidewall solder 1513 may fasten a side surface of the first circuit board 1501 to a horizontal plane of the second circuit board 1502, so that the second circuit board 1502 and the first circuit board 1501 are fastened together.

The second horizontal pad 1537 may be located at a position close to a second side surface 1522 of the second circuit board 1502. The second side surface 1522 is disposed in parallel to the first side surface 1521. The second side surface 1522 and the first side surface 1521 are located on a same side of the circuit board assembly 1500. The first side surface 1521 may be located on either side of the second side surface 1522. The first side surface 1521 and the second side surface 1522 may also be coplanar.

In an example, it is assumed that a first direction (an X direction indicated by an arrow in FIG. 15) is a direction that points from a center of the first circuit board 1501 to a periphery of the first circuit board 1501 and that is perpendicular to the first side surface 1521. The first side surface 1521 moves for a specific distance in the first direction, and may be coplanar with the second side surface 1522. As shown in FIG. 15.

In an example, it is assumed that a second direction (for example, may be a direction opposite to the X direction) is a direction that points from the periphery of the first circuit board 1501 to the center of the first circuit board 1501 and that is perpendicular to the first side surface 1521. The first side surface 1521 moves for a specific distance in the second direction, and may be coplanar with the second side surface 1522.

Similarly, the fourth horizontal pad 1538 may be located at a position close to a fourth side surface 1524 of the second circuit board 1502. The fourth side surface 1524 is disposed in parallel to the third side surface 1523. The fourth side surface 1524 and the third side surface 1523 are located on a same side of the circuit board assembly 1500. The third side surface 1523 may be located on either side of the fourth side surface 1524. The third side surface 1523 and the fourth side surface 1524 may also be coplanar.

It can be known from a drop test of the circuit board assembly that, solder balls close to a periphery of the circuit board usually bear relatively large mechanical and environmental stresses, and solder balls close to the center of the circuit board usually bear relatively small mechanical and environmental stresses. Solder is formed on a side wall, so that a solder ball closest to the periphery of the circuit board can also be protected to some extent, thereby delaying breakdown of the circuit board assembly. In addition, a spacing between adjacent circuit boards hardly affects formation of the sidewall solder. Therefore, in a case in which electrical properties of the circuit board assembly are not affected, a volume of the sidewall solder may be relatively large, so that relatively high connection strength can be implemented, and mechanical and environmental reliability of the circuit board assembly can be improved. In addition, compared with the circuit board assembly 1500 shown in FIG. 3, the circuit board assembly 1500 shown in FIG. 15 does not limit an arrangement position of the first side surface 1521 relative to the second side surface 1522, and therefore can adapt to more scenarios.

FIG. 16 is a schematic diagram of a structure of a circuit board assembly according to an embodiment of this application. A difference between a circuit board assembly 1600 shown in FIG. 16 and the circuit board assembly 1500 shown in FIG. 15 includes: A first sidewall pad 1631 includes a sidewall groove 1640, and a second horizontal pad 1637 includes a horizontal groove 1660. First sidewall solder 1612 is adhered to surfaces of the sidewall groove 1640 and the horizontal groove 1660. Similarly, the sidewall groove 1640 may be disposed on a third sidewall pad 1633, and the horizontal groove 1660 may be disposed on a fourth horizontal pad 1638. The foregoing has described beneficial effects of disposing the sidewall groove on the sidewall pad and beneficial effects of disposing the horizontal groove on the horizontal pad. Details are not described herein again.

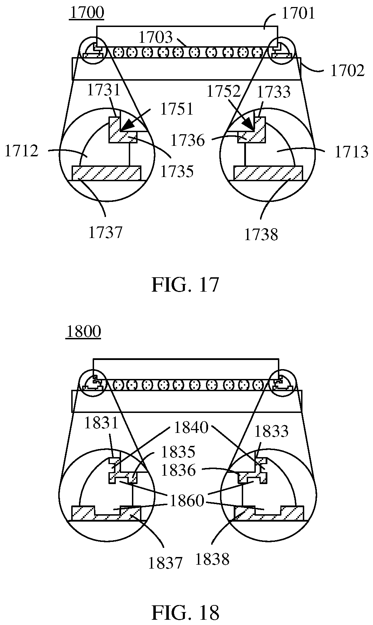

FIG. 17 is a schematic diagram of a structure of a circuit board assembly according to an embodiment of this application. A difference between a circuit board assembly 1700 shown in FIG. 17 and the circuit board assembly 1500 shown in FIG. 15 includes: A first circuit board 1701 further includes a first horizontal pad 1735. The first horizontal pad 1735 is located on a first horizontal plane 1703 that is of the first circuit board 1701 and close to a second circuit board 1702. The first horizontal pad 1735 may be located at a position close to a first sidewall pad 1731, so that first sidewall solder 1712 may also be adhered to the first horizontal pad 1735. Similarly, a third horizontal pad 1736 may be further disposed on the first circuit board 1701. The third horizontal pad 1736 is located on the first horizontal plane 1703 that is of the first circuit board 1701 and close to the second circuit board 1702, and is located at a position close to a third sidewall pad 1733. Second sidewall solder 1713 may also be adhered to the third horizontal pad 1736. Optionally, as shown in FIG. 17, the first circuit board 1701 may include a first pad 1751, and the first pad 1751 includes the first sidewall pad 1731 and the first horizontal pad 1735. The second circuit board 1702 may include a second pad 1752, and the second pad 1752 includes the third sidewall pad 1733 and the third horizontal pad 1736. The foregoing has described beneficial effects of disposing the horizontal pad and beneficial effects of connecting the sidewall pad and the horizontal pad as a whole. Details are not described herein again.

With reference to the embodiment shown in FIG. 10, it can be learned that a sidewall pad may include a sidewall groove, and a horizontal pad may include a horizontal groove. In a circuit board assembly shown in FIG. 18, each of a first sidewall pad 1831 and a third sidewall pad 1833 includes a sidewall groove 1840, and each of a first horizontal pad 1835, a second horizontal pad 1837, a third horizontal pad 1836, and a fourth horizontal pad 1838 includes a horizontal groove 1860.

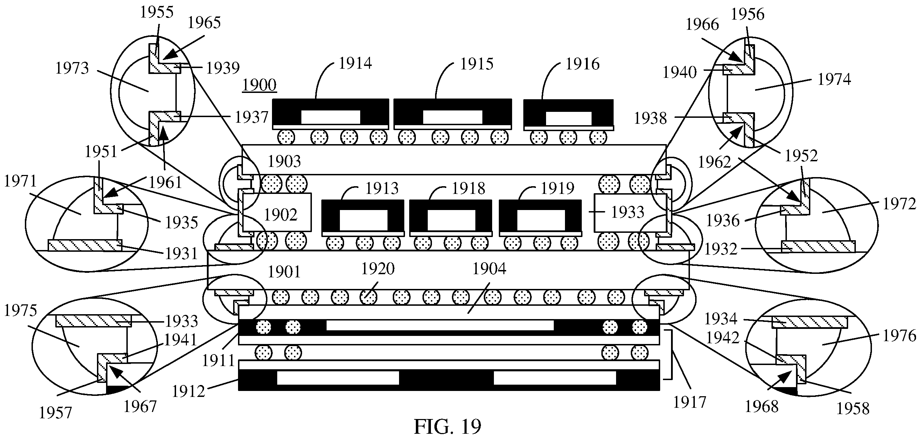

FIG. 19 is a schematic diagram of a structure of a circuit board assembly according to an embodiment of this application. With reference to the embodiment shown in FIG. 19, a person skilled in the art may think of applying the solutions in the embodiments shown in FIG. 3 to FIG. 18 to the scenario shown in FIG. 19. It should be understood that this application is not limited to the disclosed specific embodiments.

The circuit board assembly 1900 may include a plurality of circuit boards and a plurality of electronic components electrically connected to the circuit boards. The plurality of PCBs include a mainboard 1901, a frame board 1902, and a daughterboard 1903. The frame board 1902 may include vias 1933 for accommodating the electronic components. The daughterboard 1903 may be a pad land grid array (land grid array, LGA). The mainboard 1901, the frame board 1902, and the daughterboard 1903 are fastened together by using solder balls 1920, and the frame board 1902 is located between the mainboard 1901 and the daughterboard 1903. A drum pattern in FIG. 19 may represent the solder ball 1920 for mechanical and environmental fixation and/or electrical connection. Heights of solder balls at different positions may be different. For example, a height of a solder ball between the mainboard 1901 and the frame board 1902 may be about 40 µm, and a height of a solder ball between the electronic component and the circuit board may be about 150 µm.

The plurality of electronic components electrically connected to the plurality of PCBs may include, for example, an SOC component 1911, a DDR memory 1912, a primary PMU 1913, an RF IC 1914, an RF PA 1915, a Wi-Fi chip 1916, a secondary PMU 1918, and a secondary PMU 1919. The SOC component 1911 may be stacked with the DDR memory 1912 to form a POP component 1917. A substrate 1904 of the POP component 1917 may be fastened, by using the solder balls 1920, on a side that is of the mainboard 1901 and away from the frame board 1902. The PMU 1913 may be fastened, by using the solder balls 1920, on a side that is of the mainboard 1901 and close to the frame board 1902, and extends into the via 1933 of the frame board 1902. All of the RF IC 1914, the RF PA 1915, and the Wi-Fi chip 1916 may be fastened, by using the solder balls 1920, on a side that is of the daughterboard 1903 and away from the mainboard 1901.

Optionally, the mainboard 1901 further includes a horizontal pad 1931 and a horizontal pad 1932. The frame board 1902 further includes a pad 1961 and a pad 1962. The pad 1961 may include a sidewall pad 1951, a horizontal pad 1935, and a horizontal pad 1937. The horizontal pad 1935 is located on a side that is of the frame board 1902 and close to the mainboard 1901, and the horizontal pad 1937 is located on a side that is of the frame board 1902 and close to the daughterboard 1903. The pad 1962 may include a sidewall pad 1952, a horizontal pad 1936, and a horizontal pad 1938. The horizontal pad 1936 is located on the side that is of the frame board 1902 and close to the mainboard 1901, and the horizontal pad 1938 is located on the side that is of the frame board 1902 and close to the daughterboard 1903. Sidewall solder 1971 may be adhered to the horizontal pad 1931, the sidewall pad 1951, and the horizontal pad 1935, and sidewall solder 1972 may be adhered to the horizontal pad 1932, the sidewall pad 1952, and the horizontal pad 1936, to enhance reliability of a connection between the mainboard 1901 and the frame board 1902.

Optionally, the daughterboard 1903 further includes a pad 1965 and a pad 1966. The pad 1965 may include a sidewall pad 1955 and a horizontal pad 1939. The pad 1966 may include a sidewall pad 1956 and a horizontal pad 1940. Sidewall solder 1973 may be adhered to the sidewall pad 1951, the horizontal pad 1937, the sidewall pad 1955, and the horizontal pad 1939, and sidewall solder 1974 may be adhered to the sidewall pad 1952, the horizontal pad 1938, the sidewall pad 1956, and the horizontal pad 1940, to enhance reliability of a connection between the frame board 1902 and the daughterboard 1903.

Optionally, the mainboard 1901 further includes a horizontal pad 1933 and a horizontal pad 1934. The substrate 1904 of the POP component 1917 further includes a pad 1967 and a pad 1968. The pad 1967 may include a sidewall pad 1957 and a horizontal pad 1941, and the pad 1968 may include a sidewall pad 1958 and a horizontal pad 1942. Sidewall solder 1975 may be adhered to the horizontal pad 1933, the sidewall pad 1957, and the horizontal pad 1941, and sidewall solder 1976 may be adhered to the horizontal pad 1934, the sidewall pad 1958, and the horizontal pad 1942, to enhance reliability of a connection between the mainboard 1901 and the POP component 1917.

It should be noted that the sidewall pad 1951, the horizontal pad 1935, and the horizontal pad 1937 that are disposed on the frame board 1902 may form a complete pad 1961. The sidewall pad 1952, the horizontal pad 1936, and the horizontal pad 1938 that are disposed on the frame board 1902 may form a complete pad 1962. In addition, the pad 1961 and the pad 1962 may wrap a periphery of the frame board 1902, which helps shield an electromagnetic signal of the PMU 1913.

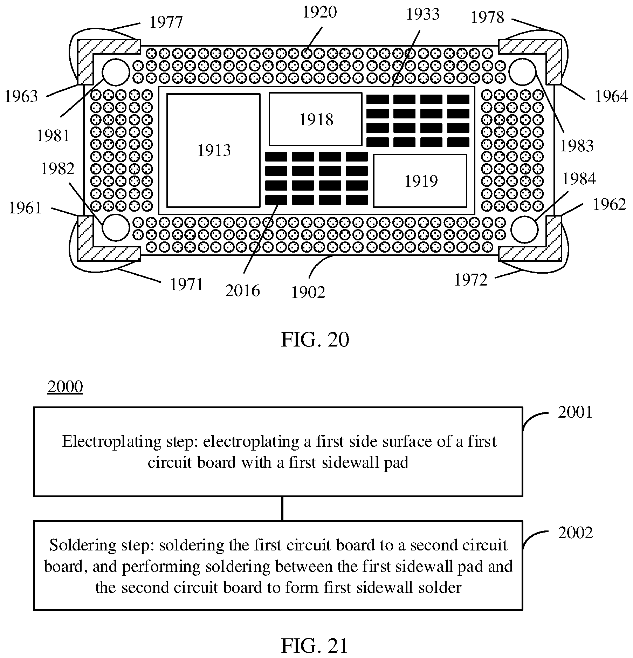

An example in FIG. 20 shows several possible positions of a pad on the frame board 1902. A circle filled with black dots in FIG. 20 may represent the solder balls 1920 connected between the frame board 1902 and the mainboard 1901. A black solid rectangle may represent a small electronic component 2016 disposed in the via 1933 of the frame board 1902, for example, may be a capacitor, a resistor, or an inductor. Electronic components disposed in the via 1933 of the frame board 1902 may further include a plurality of PMUs, such as the primary PMU 1913, the secondary PMU 1918, and the secondary PMU 1919. For example, the primary PMU 1913 may supply power to the SOC component 1911, the DDR memory 1912, an antenna module, a camera, a mobile communications chip, and the like. For example, the primary PMU 1913 may be further responsible for power-on and power-off sequence control and low-power consumption control of all system power supplies. For example, the secondary PMU 1918 and the secondary PMU 1919 may supply power to an application processor, a graphics processing unit (graphics processing unit, GPU), a memory, and the like.

The circuit board assembly 1900 may further include a screw hole 1981, a screw hole 1982, a screw hole 1983, and a screw hole 1984. The screw hole 1981, the screw hole 1982, the screw hole 1983, and the screw hole 1984 are respectively located at four corners of the frame board 1902. Therefore, the circuit board assembly 1900 may further include a plurality of screws (not shown in FIG. 20) that respectively pass through the screw hole 1981, the screw hole 1982, the screw hole 1983, and the screw hole 1984, so that the mainboard 1901, the frame board 1902, and the daughterboard 1903 in FIG. 19 are fastened on a middle frame of an electronic device. The frame board 1902 includes the pad 1961, the pad 1962, a pad 1963, and a pad 1964. Because a distance between each of the four corners of the frame board 1902 and a center of the frame board 1902 is relatively long, the four corners are more vulnerable to a strong mechanical impact. Therefore, the pad 1961, the pad 1962, the pad 1963, and the pad 1964 may be respectively located at the four corners of the frame board 1902. The pad 1961, the pad 1962, the pad 1963, and the pad 1964 each include a horizontal pad and a sidewall pad. The sidewall solder 1971, the sidewall solder 1972, sidewall solder 1977, and sidewall solder 1978 are respectively adhered to the pad 1961, the pad 1962, the pad 1963, and the pad 1964, to enhance reliability of a connection between the mainboard 1901 and the frame board 1902. Sidewall solder may not be disposed at a position relatively close to the center of the frame board 1902.

The solder ball may be formed by using a conventional soldering technology. It can be learned from the examples shown in FIG. 3 to FIG. 20 that a soldering technology for forming the sidewall solder is slightly different from the conventional soldering technology. FIG. 21 is a schematic flowchart of a method for processing a circuit board assembly according to an embodiment of this application.

2001: An electroplating step, including: electroplating a first side surface of a first circuit board with a first sidewall pad.

Optionally, the electroplating step further includes: electroplating a second side surface of a second circuit board with a second sidewall pad. The second sidewall pad is located at a position close to the first sidewall pad, and the second side surface and the first side surface are disposed in parallel to each other, and are located on a same side of the circuit board assembly.

Optionally, the electroplating step further includes: electroplating a third side surface of a first circuit board with a third sidewall pad.

Optionally, the electroplating step further includes: electroplating a fourth side surface of the second circuit board with a fourth sidewall pad. The fourth sidewall pad is located at a position close to the third sidewall pad, and the fourth side surface and the third side surface are disposed in parallel to each other, and are located on a same side of the circuit board assembly.

Optionally, the electroplating step further includes: electroplating a first horizontal plane of the first circuit board with a first horizontal pad. The first horizontal plane is a horizontal plane that is of the first circuit board and close to the second circuit board.

Optionally, the electroplating step further includes: electroplating a second horizontal plane of the second circuit board with a second horizontal pad. The second horizontal plane is a horizontal plane that is of the second circuit board and close to the first circuit board, and the second horizontal pad is located at the position close to the first sidewall pad.

Optionally, the electroplating step further includes: electroplating the first horizontal plane of the first circuit board with a third horizontal pad. The first horizontal plane is the horizontal plane that is of the first circuit board and close to the second circuit board, and the third horizontal pad is located at the position close to the third sidewall pad.

Optionally, the electroplating step further includes: electroplating the second horizontal plane of the second circuit board with a fourth horizontal pad. The second horizontal plane is the horizontal plane that is of the second circuit board and close to the first circuit board, and the fourth horizontal pad is located at a position close to the fourth sidewall pad.

Optionally, the electroplating step further includes: electroplating the first sidewall pad to form a sidewall groove.

Optionally, the electroplating step further includes: electroplating the second sidewall pad to form a sidewall groove.

Optionally, the electroplating step further includes: electroplating the third sidewall pad to form a sidewall groove.

Optionally, the electroplating step further includes: electroplating the fourth sidewall pad to form a sidewall groove.

Optionally, the electroplating step further includes: electroplating the first horizontal pad to form a horizontal groove.

Optionally, the electroplating step further includes: electroplating the second horizontal pad to form a horizontal groove.

Optionally, the electroplating step further includes: electroplating the third horizontal pad to form a horizontal groove.

Optionally, the electroplating step further includes: electroplating the fourth horizontal pad to form a horizontal groove.

2002: A soldering step, including: soldering the first circuit board to the second circuit board, and performing soldering between the first sidewall pad and the second circuit board to form first sidewall solder.

Optionally, the soldering step further includes: performing soldering between the first sidewall pad and the second sidewall pad to form the first sidewall solder.

Optionally, the soldering step further includes: performing soldering between the first sidewall pad and the second horizontal pad to form the first sidewall solder.

Optionally, the soldering step further includes: performing soldering among the first sidewall pad, the first horizontal pad, and the second sidewall pad to form the first sidewall solder.

Optionally, the soldering step further includes: performing soldering among the first sidewall pad, the first horizontal pad, the second sidewall pad, and the second horizontal pad to form the first sidewall solder.

Optionally, the soldering step further includes: performing soldering between the third sidewall pad and the fourth sidewall pad to form second sidewall solder.

Optionally, the soldering step further includes: performing soldering among the third sidewall pad, the third horizontal pad, and the fourth sidewall pad to form the second sidewall solder.

Optionally, the soldering step further includes: performing soldering among the third sidewall pad, the third horizontal pad, the fourth sidewall pad, and the fourth horizontal pad to form the second sidewall solder.

The circuit board assemblies shown in FIG. 3 to FIG. 19 may be formed by using the method shown in FIG. 21.

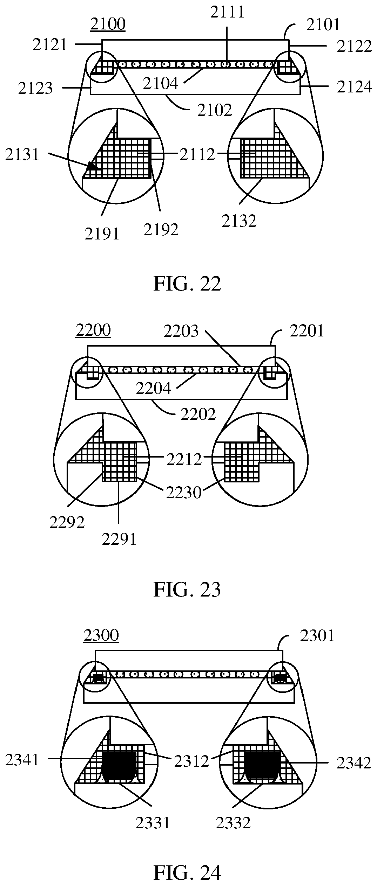

FIG. 22 is a schematic diagram of a structure of a circuit board assembly according to an embodiment of this application. A circuit board assembly 2100 may be, for example, the circuit board assembly 30 in FIG. 1, or a part of the circuit board assembly 30.

The circuit board assembly 2100 may include a first circuit board 2101 and a second circuit board 2102. The first circuit board 2101 may be fastened to the second circuit board 2102 by using solder balls 2111. In an example, the first circuit board 2101 may be, for example, the frame board 202 in FIG. 2, and the second circuit board 2102 may be, for example, the mainboard 201 in FIG. 2. In an example, the first circuit board 2101 may be, for example, the daughterboard 203 in FIG. 2, and the second circuit board 2102 may be, for example, the frame board 202 in FIG. 2. In an example, the first circuit board 2101 may be, for example, the substrate 204 included in the POP component in FIG. 2, and the second circuit board 2102 may be, for example, the mainboard 201 in FIG. 2.

The first circuit board 2101 includes a first side surface 2121. The second circuit board 2102 may include a first groove 2131. The first groove 2131 is disposed on a second horizontal plane 2104 that is of the second circuit board 2102 and close to the first circuit board 2101, and is located at a position close to the first side surface 2121. The circuit board assembly 2100 may include a filling material 2112. The filling material 2112 may be adhered between the first groove 2131 and the first circuit board 2101. Therefore, the first groove 2131 may accommodate the filling material 2112.

Similarly, the first circuit board 2101 includes a second side surface 2122. The second circuit board 2102 may include a second groove 2132. The second groove 2132 is disposed on the second horizontal plane 2104 that is of the second circuit board 2102 and close to the first circuit board 2101, and is located at a position close to the second side surface 2122. The filling material 2112 may be adhered between the second groove 2132 and the first circuit board 2101.

It should be noted that a side surface of a circuit board may refer to a surface disposed in parallel to a height direction of the circuit board. For example, a frame board is a circuit board. The frame board may include a via for disposing an electronic component. A side surface of the frame board may include an inner wall of the via, and may further include an outer peripheral surface of the frame board. A surface perpendicular to the height direction of the circuit board may be referred to as a horizontal plane of the circuit board. The circuit board may include an upper horizontal plane and a lower horizontal plane. The horizontal plane of the circuit board may be used to carry another circuit board or electronic component.

It should be noted that, in the example shown in FIG. 22, optionally, the second circuit board 2102 includes a third side surface 2123 disposed in parallel to the first side surface 2121. The first side surface 2121 and the third side surface 2123 may be located on a same side of the circuit board assembly 2100, and the third side surface 2123 is located on a side that is of the first side surface 2121 and away from the first circuit board 2101. Similarly and optionally, the second circuit board 2102 includes a fourth side surface 2124 disposed in parallel to the second side surface 2122. The second side surface 2122 and the fourth side surface 2124 may be located on a same side of the circuit board assembly 2100, and the fourth side surface 2124 is located on a side that is of the second side surface 2122 and away from the first circuit board 2101. In this case, the second circuit board 2102 may carry the filling material 2112, so that the filling material 2112 flows into a groove on the second circuit board 2102 and is adhered to the first circuit board 2101.

It can be known from a drop test of the circuit board assembly that, solder balls close to a periphery of the circuit board usually bear relatively large mechanical and environmental stresses, and solder balls close to the center of the circuit board usually bear relatively small mechanical and environmental stresses. The filling material is disposed on a side surface of a circuit, so that a solder ball closest to a periphery of the circuit board can also be protected to some extent, thereby delaying breakdown of the circuit board assembly. In addition, a groove is disposed, so that a contact area between the filling material and the circuit board can be increased, and a total adhesion volume of the filling material can be increased. This can implement relatively high connection strength, and helps improve mechanical and environmental reliability of the circuit board assembly.

It should be noted that the first groove 2131 may include a bottom surface 2191 and a groove wall 2192. The bottom surface 2191 is disposed in parallel to the second horizontal plane 2104 of the second circuit board 2102, and the groove wall 2192 may be connected between the bottom surface 2191 and the second horizontal plane 2104. As shown in FIG. 22, the groove wall 2192 may be located on one side of the bottom surface 2191, to be specific, the bottom surface 2191 includes a part directly connected to the groove wall 2192 and a part away from the groove wall 2192.

FIG. 23 is a schematic diagram of a structure of a circuit board assembly according to an embodiment of this application. A difference between a circuit board assembly 2200 shown in FIG. 23 and the circuit board assembly 2100 shown in FIG. 22 includes: A groove 2230 shown in FIG. 23 and the grooves (for example, the first groove 2131 and the second groove 2132) shown in FIG. 22 have different shapes. In the circuit board assembly 2200 shown in FIG. 23, the groove 2230 may include a bottom surface 2291 and a groove wall 2292. The bottom surface 2291 is disposed in parallel to a second horizontal plane 2204 of a second circuit board 2202. The second horizontal plane 2204 is a horizontal plane that is of the second circuit board 2202 and close to a first circuit board 2201. The groove wall 2292 may be connected between the bottom surface 2291 and the second horizontal plane 2204, and surrounds a periphery of the bottom surface 2291, so that an outlet of the groove 2230 is located on the second horizontal plane 2204 of the second circuit board 2202. Optionally, a filling material 2212 may be adhered to the groove 2230, a first horizontal plane 2203 that is of the first circuit board 2201 and close to the second circuit board 2202, and the second horizontal plane 2204 that is of the second circuit board 2202 and close to the first circuit board 2201. Compared with the groove 2230 shown in FIG. 22, when filling areas are approximately the same, the groove 2230 shown in FIG. 23 can accommodate more filling materials 2212, and the groove 2230 has a larger contact area with the filling material 2212. Therefore, a connection effect of the filling material 2212 is better, and stronger mechanical and environmental reliability can be implemented.

FIG. 24 is a schematic diagram of a structure of a circuit board assembly according to an embodiment of this application. A difference between a circuit board assembly 2300 shown in FIG. 24 and the circuit board assembly 2100 shown in FIG. 22 includes: The circuit board assembly 2300 further includes a first electronic component 2341, where the first electronic component 2341 is disposed in space between a first groove 2331 and a first circuit board 2301 (for example, disposed on a bottom surface of the first groove 2331), and a filling material 2312 adhered to the first groove 2331 wraps the first electronic component 2341. That is, the first electronic component 2341 may be disposed in the first groove 2331. Similarly, the circuit board assembly 2300 further includes a second electronic component 2342, where the second electronic component 2342 is disposed in space between a second groove 2332 and the first circuit board 2301 (for example, disposed on a bottom surface of the second groove 2332), and the filling material 2312 adhered to the second groove 2332 wraps the second electronic component 2342. That is, the second electronic component 2342 may be disposed in the second groove 2332. Some electronic components of a very small size, such as a capacitor, may be disposed on the circuit board assembly. Because the circuit board includes a groove, space between circuit boards can accommodate electronic components of a relatively small size. An electronic component is disposed in the groove, so that a quantity of electronic components that can be carried by the circuit board assembly can be increased without increasing space occupied by the circuit board assembly, and arrangement compactness of the electronic components can be improved. In other words, when the quantity of electronic components is fixed, the space occupied by the circuit board assembly can be reduced, and arrangement convenience of the electronic components can be improved.

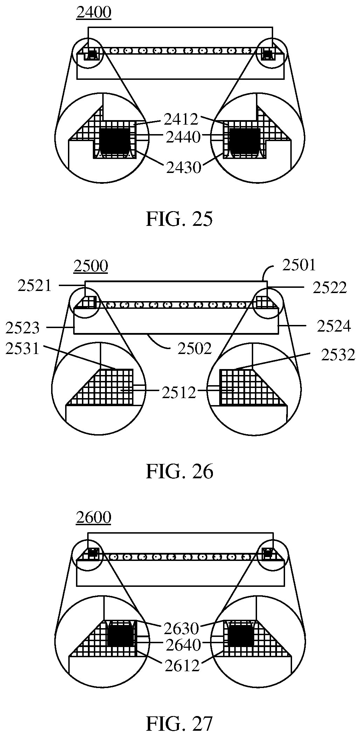

It can be learned from the embodiment shown in FIG. 23 that the groove 2230 may include a bottom surface and a groove wall surrounding the bottom surface. It can be learned from the embodiment shown in FIG. 24 that electronic components (for example, the first electronic component 2341 and the second electronic component 2342) may be disposed in the grooves (for example, the first groove 2331 and the second groove 2332), and the filling material 2312 may wrap the electronic components in the grooves. Therefore, compared with the example shown in FIG. 22, FIG. 25 shows a different example. Differences include grooves 2430 of different shapes and electronic components 2440 disposed in the grooves 2430 of different shapes. A filling material 2412 may wrap the electronic components 2440 in the grooves 2430 of different shapes. Corresponding beneficial effects have been described above by using FIG. 23 and FIG. 24. Details are not described herein again.

FIG. 26 is a schematic diagram of a structure of a circuit board assembly according to an embodiment of this application. A difference between a circuit board assembly 2500 shown in FIG. 26 and the circuit board assembly 2100 shown in FIG. 22 includes: A second circuit board 2502 includes a third side surface 2523 disposed in parallel to a first side surface 2521. The first side surface 2521 and the third side surface 2523 are located on a same side of the circuit board assembly 2500, and the third side surface 2523 is located on a side that is of the first side surface 2521 and close to a first circuit board 2501. Similarly and optionally, the second circuit board 2502 includes a fourth side surface 2524 disposed in parallel to a second side surface 2522. The second side surface 2522 and the fourth side surface 2524 are located on a same side of the circuit board assembly 2500, and the fourth side surface 2524 is located on a side that is of the second side surface 2522 and close to the first circuit board 2501. In this case, the first circuit board 2501 may carry a filling material 2512, so that the filling material 2512 flows into a first groove 2531 or a second groove 2532, and is adhered to the second circuit board 2502. Compared with the circuit board assembly 2500 shown in FIG. 26, the grooves (for example, the first groove 2131 and the second groove 2132) shown in FIG. 22 may be used to carry the filling material 2112, which helps plan a flow direction of the filling material 2112.

FIG. 27 is a schematic diagram of a structure of a circuit board assembly according to an embodiment of this application. A difference between a circuit board assembly 2600 shown in FIG. 27 and the circuit board assembly 2500 shown in FIG. 26 includes: Electronic components 2640 are disposed in grooves 2630 shown in FIG. 27, and filling materials 2612 may wrap the electronic components 2640 in the grooves 2630. Corresponding beneficial effects have been described above by using FIG. 24. Details are not described herein again.

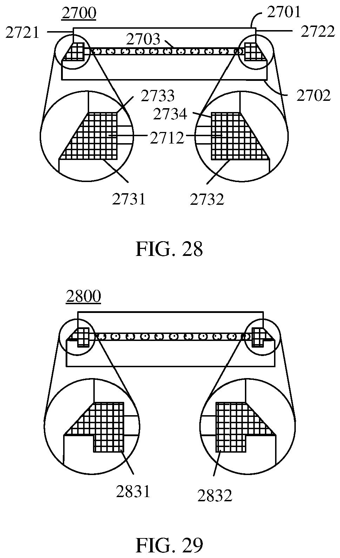

FIG. 28 is a schematic diagram of a structure of a circuit board assembly according to an embodiment of this application. A difference between a circuit board assembly 2700 shown in FIG. 28 and the circuit board assembly 2100 shown in FIG. 22 includes: A first circuit board 2701 includes a third groove 2733, where the third groove 2733 is disposed at a position close to a first side surface 2721, and is located on a first horizontal plane 2703 that is of the first circuit board 2701 and close to a second circuit board 2702. A filling material 2712 is adhered between a first groove 2731 and the third groove 2733. Similarly, the first circuit board 2701 includes a fourth groove 2734. The fourth groove 2734 is disposed at a position close to a second side surface 2722, and is located on the first horizontal plane 2703 that is of the first circuit board 2701 and close to the second circuit board 2702. The filling material 2712 is adhered between a second groove 2732 and the fourth groove 2734. Grooves are disposed on both the first circuit board and the second circuit board, so that a height for accommodating the filling material between the first circuit board and the second circuit board can be increased, a volume of the filling material can be increased, and a contact area between the filling material and each of the first circuit board and the second circuit board can be increased. This can implement relatively high connection strength, and helps improve mechanical and environmental reliability of the circuit board assembly.

FIG. 29 is a schematic diagram of a structure of a circuit board assembly according to an embodiment of this application. A difference between a circuit board assembly 2800 shown in FIG. 29 and the circuit board assembly 2700 shown in FIG. 28 includes: A shape of a first groove 2831 shown in FIG. 29 is different from a shape of the first groove 2731 shown in FIG. 28; and a shape of a second groove 2832 shown in FIG. 29 is different from a shape of the second groove 2732 shown in FIG. 28. Corresponding beneficial effects have been described above by using FIG. 23. Details are not described herein again.

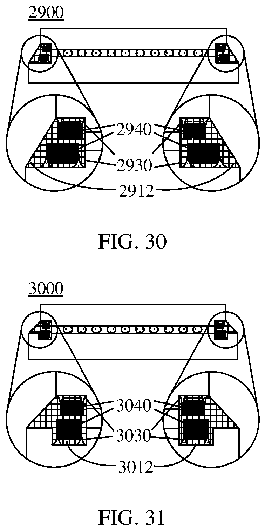

FIG. 30 is a schematic diagram of a structure of a circuit board assembly according to an embodiment of this application. A difference between a circuit board assembly 2900 shown in FIG. 30 and the circuit board assembly 2700 shown in FIG. 28 includes: Electronic components 2940 are disposed in grooves 2930 shown in FIG. 30, and filling materials 2912 may wrap the electronic components 2940 in the grooves 2930. Corresponding beneficial effects have been described above by using FIG. 24. Details are not described herein again.

FIG. 31 is a schematic diagram of a structure of a circuit board assembly according to an embodiment of this application. A difference between a circuit board assembly 3000 shown in FIG. 31 and the circuit board assembly 2800 shown in FIG. 29 includes: Electronic components 3040 are disposed in grooves 3030 shown in FIG. 31, and filling materials 3012 may wrap the electronic components 3040 in the grooves 3030. Corresponding beneficial effects have been described above by using FIG. 24. Details are not described herein again.

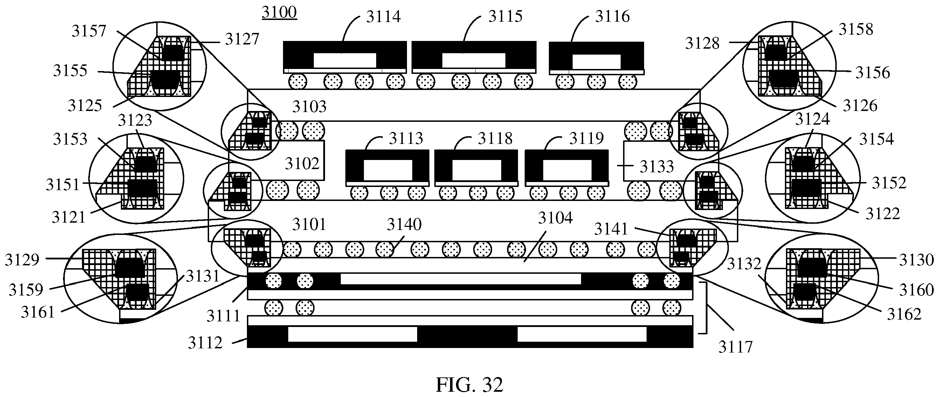

FIG. 32 is a schematic diagram of a structure of a circuit board assembly according to an embodiment of this application. With reference to the embodiment shown in FIG. 32, a person skilled in the art may think of applying the solutions in the embodiments shown in FIG. 22 to FIG. 31 to the scenario shown in FIG. 32. It should be understood that this application is not limited to the disclosed specific embodiments.

The circuit board assembly 3100 may include a plurality of circuit boards and a plurality of electronic components electrically connected to the circuit boards. The plurality of PCBs include a mainboard 3101, a frame board 3102, and a daughterboard 3103. The frame board 3102 may include vias 3133 for accommodating the electronic components. The daughterboard 3103 may be a pad land grid array (land grid array, LGA). The mainboard 3101, the frame board 3102, and the daughterboard 3103 are fastened together by using solder balls 3140, and the frame board 3102 is located between the mainboard 3101 and the daughterboard 3103. A drum pattern in FIG. 32 may represent a solder ball 3140 for mechanical and environmental fixation and/or electrical connection. Heights of solder balls at different positions may be different. For example, a height of a solder ball between the mainboard 3101 and the frame board 3102 may be about 40 µm, and a height of a solder ball between the electronic component and the circuit board may be about 150 µm.

The plurality of electronic components electrically connected to the plurality of PCBs may include, for example, an SOC component 3111, a DDR memory 3112, a primary PMU 3113, an RF IC 3114, an RF PA 3115, a Wi-Fi chip 3116, a secondary PMU 3118, and a secondary PMU 3119. The SOC component 3111 may be stacked with the DDR memory 3112 to form a POP component 3117. A substrate 3104 of the POP component 3117 may be fastened, by using the solder balls 3140, on a side that is of the mainboard 3101 and away from the frame board 3102. The PMU 3113 may be fastened, by using the solder balls 3140, on a side that is of the mainboard 3101 and close to the frame board 3102, and extends into the via 3133 of the frame board 3102. All of the RF IC 3114, the RF PA 3115, and the Wi-Fi chip 3116 may be fastened, by using the solder balls 3140, on a side that is of the daughterboard 3103 and away from the mainboard 3101.

Optionally, the mainboard 3101 further includes a groove 3121 and a groove 3122. The frame board 3102 further includes a groove 3123 and a groove 3124. Reliability of a connection between the mainboard 3101 and the frame board 3102 may be enhanced by adhering a filling material 3141 between the groove 3121 and the groove 3123 and adhering the filling material 3141 between the groove 3122 and the groove 3124. Optionally, a capacitor 3151 may be disposed in the groove 3121. Optionally, a capacitor 3152 may be disposed in the groove 3122. Optionally, a capacitor 3153 may be disposed in the groove 3123. Optionally, a capacitor 3154 may be disposed in the groove 3124. A size of the mainboard 3101 is generally slightly larger than a size of the frame board 3102. Therefore, optionally, a groove on the mainboard 3101 may include a bottom surface and a groove wall, the groove wall surrounds a periphery of the bottom surface, and the groove wall is connected between the bottom surface and a horizontal plane of the mainboard 3101. A groove on the frame board 3102 may include a bottom surface and a groove wall, the groove wall is located on one side of the bottom surface, and the groove wall is connected between the bottom surface and a horizontal plane of the frame board 3102.

Optionally, the frame board 3102 further includes a groove 3125 and a groove 3126. The daughterboard 3103 further includes a groove 3127 and a groove 3128. Reliability of a connection between the frame board 3102 and the daughterboard 3103 may be enhanced by adhering the filling material 3141 between the groove 3125 and the groove 3127 and adhering the filling material 3141 between the groove 3126 and the groove 3128. Optionally, a capacitor 3155 may be disposed in the groove 3125. Optionally, a capacitor 3156 may be disposed in the groove 3126. Optionally, a capacitor 3157 may be disposed in the groove 3127. Optionally, a capacitor 3158 may be disposed in the groove 3128.

Optionally, the mainboard 3101 further includes a groove 3129 and a groove 3130. The substrate 3104 of the POP component 3117 further includes a groove 3131 and a groove 3132. Reliability of a connection between the mainboard 3101 and the POP component 3117 may be enhanced by adhering the filling material 3141 between the groove 3129 and the groove 3131 and adhering the filling material 3141 between the groove 3130 and the groove 3132. Optionally, a capacitor 3159 may be disposed in the groove 3129. Optionally, a capacitor 3160 may be disposed in the groove 3130. Optionally, a capacitor 3161 may be disposed in the groove 3131. Optionally, a capacitor 3162 may be disposed in the groove 3132.

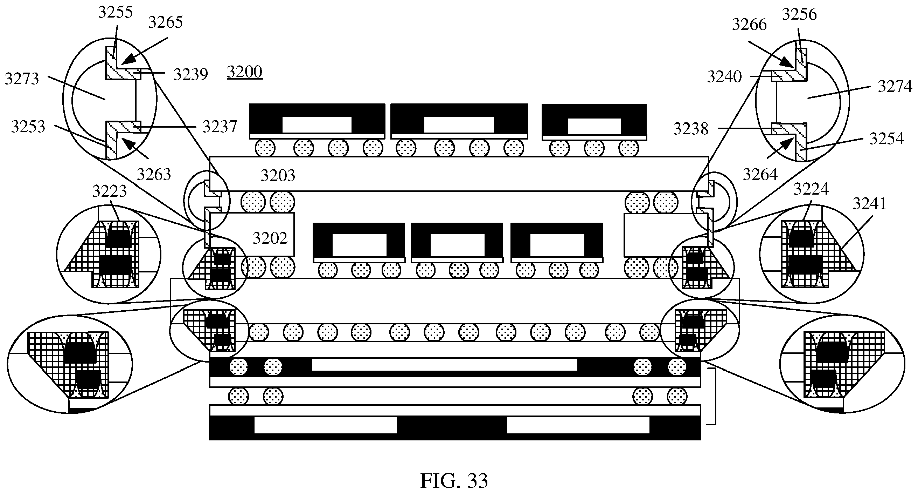

FIG. 33 is a schematic diagram of a structure of a circuit board assembly according to an embodiment of this application. A difference between a circuit board assembly 3200 and the circuit board assembly 3100 shown in FIG. 32 includes: A frame board 3202 further includes a pad 3263 and a pad 3264. The pad 3263 may include a sidewall pad 3253 and a horizontal pad 3237, and the pad 3264 may include a sidewall pad 3254 and a horizontal pad 3238. A daughterboard 3203 further includes a pad 3265 and a pad 3266. The pad 3265 may include a sidewall pad 3255 and a horizontal pad 3239, and the pad 3266 may include a sidewall pad 3256 and a horizontal pad 3240. Sidewall solder 3273 may be adhered to the sidewall pad 3253, the horizontal pad 3237, the sidewall pad 3255, and the horizontal pad 3239, and sidewall solder 3274 may be adhered to the sidewall pad 3254, the horizontal pad 3238, the sidewall pad 3256, and the horizontal pad 3240, to enhance reliability of a connection between the frame board 3202 and the daughterboard 3203.

It should be noted that a groove 3223 and a groove 3224 for adhering a filling material are disposed on a side that is of the frame board 3202 and away from the daughterboard 3203, as shown in FIG. 33. One end that is of the sidewall pad 3253 and away from the horizontal pad 3237 may be coplanar with a bottom surface of the groove 3223. One end that is of the sidewall pad 3254 and away from the horizontal pad 3238 may be coplanar with a bottom surface of the groove 3224. In other words, the end that is of the sidewall pad 3253 and away from the horizontal pad 3237 may extend to the groove 3223, and the end that is of the sidewall pad 3254 and away from the horizontal pad 3238 may extend to the groove 3224. Therefore, a sidewall pad may wrap a part of a periphery of the frame board 3202, to implement an electromagnetic shielding function. For a pad disposed on the frame board 2302, refer to the example in FIG. 20. Details are not described herein again.

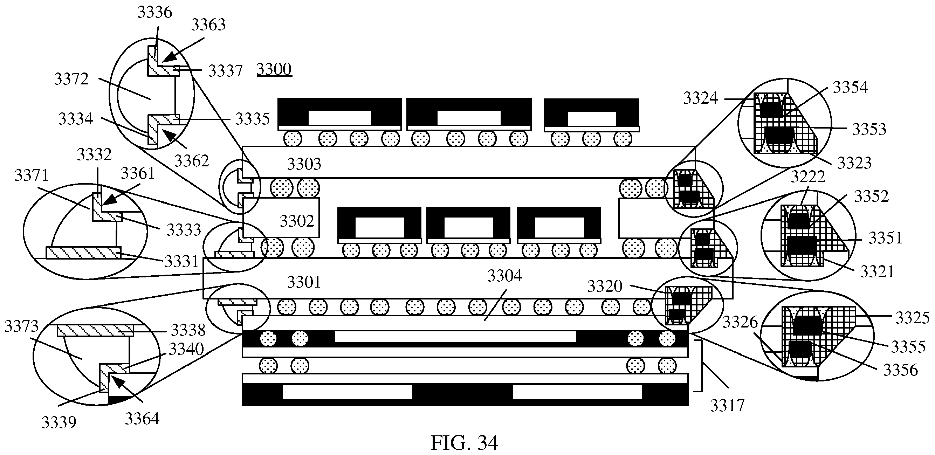

FIG. 34 is a schematic diagram of a structure of a circuit board assembly according to an embodiment of this application. A difference between a circuit board assembly 3300 and the circuit board assembly 3100 shown in FIG. 32 includes the following:

In a first aspect, a mainboard 3301 further includes a horizontal pad 3331 and a groove 3321. A frame board 3302 further includes a pad 3361 and a groove 3322. The pad 3361 may include a sidewall pad 3332 and a horizontal pad 3333. Sidewall solder 3371 may be adhered to the horizontal pad 3331, the sidewall pad 3332, and the horizontal pad 3333, and a filling material 3320 may be adhered to the groove 3321 and the groove 3322, to enhance reliability of a connection between the mainboard 3301 and the frame board 3302. Optionally, a capacitor 3351 may be disposed in the groove 3321. Optionally, a capacitor 3352 may be disposed in the groove 3322. A size of the mainboard 3301 is generally slightly larger than a size of the frame board 3302. Therefore, optionally, a groove on the mainboard 3301 may include a bottom surface and a groove wall, the groove wall surrounds a periphery of the bottom surface, and the groove wall is connected between the bottom surface and a horizontal plane of the mainboard 3301. A groove on the frame board 3302 may include a bottom surface and a groove wall, the groove wall is located on one side of the bottom surface, and the groove wall is connected between the bottom surface and a horizontal plane of the frame board 3302.

In a second aspect, the frame board 3302 further includes a pad 3362 and a groove 3323. The pad 3362 may include a sidewall pad 3334 and a horizontal pad 3335. A daughterboard 3303 further includes a pad 3363 and a groove 3324. The pad 3363 may include a sidewall pad 3336 and a horizontal pad 3337. Sidewall solder 3372 may be adhered to the sidewall pad 3334, the horizontal pad 3335, the sidewall pad 3336, and the horizontal pad 3337, and the filling material 3320 may be adhered to the groove 3323 and the groove 3324, to enhance reliability of a connection between the frame board 3302 and the daughterboard 3303. Optionally, a capacitor 3353 may be disposed in the groove 3323. Optionally, a capacitor 3354 may be disposed in the groove 3324.

In a third aspect, a mainboard 3301 further includes a horizontal pad 3338 and a groove 3325. A substrate 3304 of a POP component 3317 further includes a pad 3364 and a groove 3326. The pad 3364 may include a sidewall pad 3339 and a horizontal pad 3340. Sidewall solder 3373 may be adhered to the horizontal pad 3338, the sidewall pad 3339, and the horizontal pad 3340, and the filling material 3320 may be adhered to the groove 3325 and the groove 3326, to enhance reliability of a connection between the mainboard 3301 and the POP component 3317. Optionally, a capacitor 3355 may be disposed in the groove 3325. Optionally, a capacitor 3356 may be disposed in the groove 3326.

It should be noted that the pad 3361 and the pad 3362 disposed on the frame board 3302 are two different pads. Therefore, random flow of sidewall solder on a side surface of the frame board 3302 can be limited, to improve shape consistency of the sidewall solder.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A circuit board assembly, comprising:
a first circuit board, comprising a first side surface and a first sidewall pad, wherein the first sidewall pad is disposed on the first side surface;
a second circuit board, fastened to the first circuit board, wherein the first sidewall pad is located at a position close to the second circuit board; and
sidewall solder, adhered to the first sidewall pad and the second circuit board.

2. The circuit board assembly according to claim 1, wherein the second circuit board comprises a second horizontal pad, and the second horizontal pad is disposed on a second horizontal plane that is of the second circuit board and close to the first circuit board; and
that the sidewall solder is adhered to the first sidewall pad and the second circuit board is specifically:
the sidewall solder is adhered to the first sidewall pad and the second horizontal pad.

3. The circuit board assembly according to claim 1, wherein the second circuit board comprises a second side surface and a second sidewall pad, the first side surface and the second side surface are located on a same side of the circuit board assembly, and the second sidewall pad is disposed at a position that is on the second side surface and close to the first circuit board; and
that the sidewall solder is adhered to the first sidewall pad and the second circuit board is specifically:
the sidewall solder is adhered to the first sidewall pad and the second sidewall pad.

4. The circuit board assembly according to any one of claims 1 to 3, wherein the first sidewall pad further comprises a sidewall groove, and the sidewall solder is adhered to a surface of the sidewall groove.

5. The circuit board assembly according to claim 4, wherein the sidewall groove comprises a first bottom surface and a first groove wall, the first bottom surface is disposed in parallel to the first side surface, the first groove wall is connected between the first bottom surface and an outer surface of the first sidewall pad, and the first groove wall surrounds a periphery of the first bottom surface, or the first groove wall is located on one side of the first bottom surface.

6. The circuit board assembly according to any one of claims 1 to 5, wherein the first circuit board further comprises:
a first horizontal pad, located on a first horizontal plane that is of the first circuit board and close to the second circuit board, and located at a position close to the first sidewall pad, wherein the sidewall solder is further adhered to the first horizontal pad.

7. The circuit board assembly according to claim 6, wherein the first horizontal pad is connected to the first sidewall pad to form a first pad.

8. The circuit board assembly according to claim 6 or 7, wherein the first horizontal pad further comprises a horizontal groove, and the sidewall solder is adhered to a surface of the horizontal groove.

9. The circuit board assembly according to claim 8, wherein the horizontal groove comprises a second bottom surface and a second groove wall, the second bottom surface is disposed in parallel to the first horizontal plane, the second groove wall is connected between the second bottom surface and an outer surface of the first horizontal pad, and the second groove wall surrounds a periphery of the second bottom surface, or the second groove wall is located on one side of second bottom surface.

10. The circuit board assembly according to any one of claims 1 to 9, wherein one end that is of the first sidewall pad and far away from the second circuit board extends to a third horizontal plane, and the third horizontal plane is a horizontal plane that is of the first circuit board and far away from the second circuit board.

11. The circuit board assembly according to any one of claims 1 to 10, wherein
the first circuit board further comprises a third side surface and a first groove, wherein the first groove is located at a position close to the third side surface, and is located on the first horizontal plane that is of the first circuit board and close to the second circuit board; and
the circuit board assembly further comprises:
a filling material, adhered between the first groove and the second circuit board.

12. The circuit board assembly according to any one of claims 1 to 10, wherein
the first circuit board further comprises a third side surface, and the second circuit board further comprises a first groove, wherein the first groove is located at a position close to the third side surface, and is located on the second horizontal plane that is of the second circuit board and close to the first circuit board; and
the circuit board assembly further comprises:
a filling material, adhered between the first groove and the first circuit board.

13. The circuit board assembly according to claim 11 or 12, wherein the circuit board assembly further comprises an electronic component disposed in the first groove, and the filling material wraps the electronic component.

14. A circuit board assembly, comprising:
a first circuit board, comprising a first side surface;
a second circuit board, fastened to the first circuit board and comprising a first groove, wherein the first groove is located at a position close to the first side surface, and is disposed on a second horizontal plane that is of the second circuit board and close to the first circuit board; and
a filling material, adhered between the first circuit board and the first groove.

15. The circuit board assembly according to claim 14, wherein the first groove comprises a bottom surface and a groove wall, the bottom surface is disposed in parallel to the second horizontal plane, the groove wall is connected between the bottom surface and the second horizontal plane, and the groove wall surrounds a periphery of the bottom surface, or the groove wall is located on one side of bottom surface.

16. The circuit board assembly according to claim 14 or 15, wherein the circuit board assembly further comprises an electronic component disposed in the first groove, and the filling material wraps the electronic component.

17. The circuit board assembly according to any one of claims 14 to 16, wherein the first circuit board further comprises a third groove, the third groove is located at a position close to the first side surface, and is disposed on a first horizontal plane that is of the first circuit board and close to the second circuit board, and the filling material is adhered between the first groove and the third groove.

18. An electronic device, comprising the circuit board assembly according to any one of claims 1 to 17.

19. A method for processing a circuit board assembly, comprising:
an electroplating step, comprising: electroplating a first side surface of a first circuit board with a first sidewall pad; and
a soldering step, comprising: soldering the first circuit board to a second circuit board, and performing soldering between the first sidewall pad and the second circuit board to form sidewall solder.

20. The method according to claim 19, wherein the electroplating step further comprises:
electroplating a second side surface of the second circuit board with a second sidewall pad, wherein the second sidewall pad is located at a position close to the first sidewall pad, and the second side surface and the first side surface are disposed in parallel to each other, and are located on a same side of the circuit board assembly; and
the performing soldering between the first sidewall pad and the second circuit board to form sidewall solder comprises:
performing soldering between the first sidewall pad and the second sidewall pad to form the sidewall solder.

21. The method according to claim 19 or 20, wherein the electroplating step further comprises:
electroplating a second horizontal plane of the second circuit board with a second horizontal pad, wherein the second horizontal plane is a horizontal plane that is of the second circuit board and close to the first circuit board, and the second horizontal pad is located at a position close to the first sidewall pad; and
the performing soldering between the first sidewall pad and the second circuit board to form sidewall solder comprises:
performing soldering between the first sidewall pad and the second horizontal pad to form the sidewall solder.

22. The method according to any one of claims 19 to 21, wherein the electroplating step further comprises:
electroplating a first horizontal plane of the first circuit board with a first horizontal pad, wherein the first horizontal plane is a horizontal plane that is of the first circuit board and close to the second circuit board; and
the performing soldering between the first sidewall pad and the second circuit board to form sidewall solder comprises:
performing soldering among the first sidewall pad, the first horizontal pad, and the second circuit board to form the sidewall solder.

23. The method according to claim 22, wherein the electroplating step further comprises:
electroplating the first horizontal pad to form a horizontal groove.

24. The method according to any one of claims 19 to 23, wherein the electroplating step further comprises:
electroplating the first sidewall pad to form a sidewall groove.
